(19)

Europäisches Patentamt
European Patent Office
Office européen des brevets

(11) **EP 2 557 688 B1**

(12) **EUROPEAN PATENT SPECIFICATION**

(45) Date of publication and mention
of the grant of the patent:
**23.05.2018 Bulletin 2018/21**

(51) Int Cl.:
***H03H 7/40*** (2006.01)

(21) Application number: **11290371.1**

(22) Date of filing: **11.08.2011**

(54) **A controller for a radio circuit**

Steuerung für eine Funkschaltung

Contrôleur pour circuit radio

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**13.02.2013 Bulletin 2013/07**

(73) Proprietor: **NXP B.V.**
**5656 AG Eindhoven (NL)**

(72) Inventor: **Erdem, Aykut**
**Redhill**
**Surrey RH1 1DL (GB)**

(74) Representative: **Miles, John Richard et al**
**NXP SEMICONDUCTORS**
**Intellectual Property Group**
**Abbey House**
**25 Clarendon Road**
**Redhill, Surrey RH1 1QZ (GB)**

(56) References cited:
**EP-A1- 1 137 192          EP-A2- 2 288 023
WO-A1-2004/008634     DE-A1-102008 016 873
GB-A- 2 330 965           JP-A- 61 135 235
US-A- 5 483 688           US-A1- 2002 101 907
US-A1- 2005 255 818     US-A1- 2008 261 544
US-A1- 2009 231 220**

- **BUCKLEY J ET AL: "The detuning effects of a
  wrist-worn antenna and design of a custom
  antenna measurement system", MICROWAVE
  CONFERENCE (EUMC), 2010 EUROPEAN, IEEE,
  PISCATAWAY, NJ, USA, 28 September 2010
  (2010-09-28), pages 1738-1741, XP031785991,
  ISBN: 978-1-4244-7232-1**
- **VAN BEZOOIJEN A ET AL: "RF-MEMS based
  adaptive antenna matching module", RADIO
  FREQUENCY INTEGRATED CIRCUITS (RFIC)
  SYMPOSIUM, 2007 IEEE, IEEE, PISCATAWAY,
  NJ, USA, 1 June 2007 (2007-06-01), pages
  573-576, XP031113096, ISBN: 978-1-4244-0530-5**
- **FIRRAO E L ET AL: "An Automatic Antenna
  Tuning System Using Only RF Signal
  Amplitudes", IEEE TRANSACTIONS ON
  CIRCUITS AND SYSTEMS II: EXPRESS BRIEFS,
  IEEE, US, vol. 55, no. 9, 1 September 2008
  (2008-09-01), pages 833-837, XP011333982, ISSN:
  1549-7747, DOI: 10.1109/TCSII.2008.925652**

EP 2 557 688 B1

**Description**

The present invention relates to the field of a controller for a radio circuit. In particular although not exclusively, the controller can control an impedance matching circuit, or a variable impedance element, within a radio circuit.

The number of different types of wireless system and the allocated frequency bands for radio systems is growing rapidly. Multi-mode and multi-band integration of wireless platforms has become increasingly common because of the increased functionality of many, often converging, areas of technology. This poses many problems for radio circuit designers.

WO 2008/007330 relates to a circuit for adaptive matching of a load impedance to a predetermined load-line impedance of a load-line connected to a power amplifier output comprising a fixed matching network between the power transistor and an adaptive matching network, whereby the fixed matching network acts as an impedance inverter which results in a relatively low insertion loss at high power.

US 2009/0021325 A1 discloses a front end module. The front end module includes a plurality of antennas receiving different frequency band signals, respectively, an impedance matching circuit unit comprising a plurality of tuners respectively connected to the plurality of antennas to control impedance matching, a selection unit selecting one frequency band signal from multiple frequency band signals passing through the impedance matching circuit unit, a measuring unit measuring signal strength of a received signal selected at the selection unit, and a control unit controlling an operation of the selection unit and an impedance of the tuner according to the signal strength of the received signal measured at the measuring unit.

WO 2004/008634 A1 relates to an impedance transformation circuit is provided for use with a transmitter, a receiver, and an antenna. The transmitter may provide transmission signals for transmission by the antenna. The antenna may provide received signals having an associated signal parameter to the receiver. The impedance transformation circuit includes an impedance adjusting circuit and a controller. The impedance adjusting circuit is connected between the antenna, the receiver, and the transmitter. The impedance adjusting circuit is configured to change an impedance difference presented between the transmitter or receiver and the antenna in response to a control signal. The controller generates the control signal to change the presented impedance difference in response to a signal parameter.

US 2009/0231220 A1 discloses techniques for adjusting one or more antenna parameters to optimize the performance of a wireless device. A variable antenna match is provided with a control signal for selecting a preferred antenna match setting. The preferred antenna match setting corresponds to the setting having a best signal quality metric. In a further embodiment, a variable antenna electrical length module is provided with a control signal for selecting a preferred antenna electrical length.

J Buckley et al., "The Detuning Effects of a WristWom Antenna and Design of a Custom Antenna Measurement System", Proc. 40th Euro. Microwave Conf. (2010) 1738-1741 investigates the effects of antenna detuning on wireless devices caused by the presence of the human body, particularly the wrist.

EP 2288023 A2 relates to an impedance matching circuit for a radio. The circuit receives antenna signals and has its matching elements progressively switched into the circuit.

The matching element configuration resulting in the highest RSSI is subsequently used until a succeeding test or antenna impedance change.

EP 1137192 A1 relates to a radio station for transmitting signals. An antenna of a transmitter of the radio station is matched to an output impedance of a power amplifier by adding an impedance with a variable reactance. A processor adjusts the variable reactance of the impedance according to an output signal of the power amplifier.

US 2007/0285326 A1 discloses an apparatus comprising an adaptively-tuned antenna including a variable reactance network connected to the antenna, an RF field probe located near the antenna, an RF detector to sense voltage from the field probe, a controller that monitors the RF voltage and supplies control signals to a driver circuit and wherein the driver circuit converts the control signals to bias signals for the variable reactance network.

E. L. Firrao et al., "An Automatic Antenna Tuning System Using Only RF Signal Amplitudes", IEEE Transactions on circuits & Systems -II: Express Briefs, 55, (2008), 833 - 837, presents an automatic antenna tuner system for handheld applications that uses two series reactances combined with three simple RF peak detectors to sense both reactive and real impedance mismatches.

The listing or discussion of a prior-published document or any background in the specification should not necessarily be taken as an acknowledgement that the document or background is part of the state of the art or is common general knowledge.

According to the invention, there is provided a controller for a radio circuit in accordance with claim 1. Embodiments of the invention may be applicable tc any kind of wireless system and may have the potential for application in conjunction with "cognitive radio techniques". These techniques can include software defined radio having multi-mode, multi-band capabilities which require a level of antenna impedance matching over a wide frequency range. Setting the impedance of the variable impedance element may comprise setting the resistive part of the apparent impedance of the antenna, setting the reactive part of the apparent impedance of the antenna, or setting both the resistive and the reactive

EP 2 557 688 B1

parts of the apparent impedance of the antenna.

The impedance of the antenna and at least one variable impedance element may together be referred to as the apparent impedance of the antenna. The controller may be configured to set the apparent impedance of the antenna to be closer to, or broadly equal to, the complex conjugate of the impedance of a stage of the radio circuit thereby reducing mismatch losses. The controller may be configured to set the apparent impedance of the antenna to be closer to, or broadly equal to, the complex conjugate of the transmitter output impedance, or to the complex conjugate of the receiver input impedance. The stage of the radio circuit may be an input amplifier of a receiver or an output power amplifier of a transmitter, for example. In some embodiments, the controller may be configured to set the reactance of the variable impedance element so that an apparent reactance of the antenna is equal in magnitude and opposite in sign to the reactance of the stage of the radio circuit at a desired frequency, or range of frequencies, of operation.

The reactance may be considered as the frequency-dependant component of the apparent impedance of the antenna, In other examples, the controller may be configured to set the apparent impedance of the antenna such that it more closely matches the impedance of one or more components of the radio circuit.

The controller may be further configured to determine an equivalent reactance of the antenna using the received signal quality indicator. The controller may set the impedance of the variable impedance element responsive to the determined reactance of the antenna. The controller may determine the reactance of the antenna from information such as the received signal quality indicator. This determination may enable the controller to provide a more rapid convergence on an improved setting for the variable impedance element.

The controller may be further configured to receive a first received signal quality indicator from the received signal quality indicator generator. The controller may provide a first signal to the at least one variable impedance element. The first signal may comprise a command to modify the reactance of the at least one variable impedance element by a first reactance value. The controller may receive a second received signal quality indicator from the received signal quality indicator generator. The controller may determine a reactance of the antenna by solving a function of the first and second received signal quality indicators, and the first reactance value. The controller may provide a control signal to the at least one variable impedance element. The control signal may comprise a command to modify the impedance of the variable impedance element in accordance with the determined reactance of the antenna.

The controller may be further configured to provide a second signal tc the at least one variable impedance element. The second signal may comprise a command to modify the reactance of the at least one variable impedance element by a second reactance value. The controller may receive a third received signal quality indicator from the received signal quality indicator generator. The controller may determine a reactance value of the equivalent impedance of the antenna by solving a function of the first, second and third received signal quality indicators, and the first and second reactance values.

The second received signal quality indicator may be indicative of the receiver performance after the impedance value has been modified by the first reactance value. The third received signal quality indicator may be indicative of the receiver performance after the impedance value has been modified by the second reactance value. The function may be one or more differential equations, matrix operations or a set of simultaneous equations. The first, second and third signal reactance values may be all be equal. The reactance values associated with the first and/or second signals may differ from the reactance value associated with the third signal. Any of the reactance values may differ from any of the other reactance values.

The at least one variable impedance element to which the first signal is sent may be the same variable impedance element(s) or different variable impedance element(s) to which the second signal is sent. For example, the first and second signals may be sent to control a variable capacitor. A third signal may be sent to control a variable inductor, or a different variable capacitor. More generally, any reference herein to at least one variable impedance element may be to any variable impedance element in the radio circuit.

In various embodiments, the control signal may comprise a command for the at least one variable impedance element to set its impedance such that an apparent impedance of the antenna is brought closer to, or broadly equal to, the complex conjugate of the impecance of a stage of the radio circuit operating at a frequency. The stage of the radic circuit may be a transmitter output stage, such as a power amplifier. The stage of the radio circuit may be a receiver input stage. The term 'broadly equally with' herein may mean within 1 %, 2 %, 5 %, 10 % or 20 % of a value.

The apparent antenna reactance may be equal to the reactance of the antenna plus the reactance of the at least one variable impedance element. The operating frequency may be the operating frequency of a receiver or a transmitter, or a combined operating frequency of the receiver and transmitter, for instance a frequency between the receiver operating frequency and the transmitter operating frequency.

The reactance of the at least one variable impedance element may be set so as to oppose the reactance of the antenna. By oppose, it may be meant that the reactance of the at least one variable impedance element is of a different sign to the reactance of the antenna. Inductive reactance is of a different sign to capacitive reactance. The controller may reduce the impedance mismatch between the antenna and the radio circuit thereby improving the performance of the circuit.

3

The magnitude of the reactance of the variable impedance element may be set such that it is brought closer to, or broadly equal to, the reactance of the antenna plus the reactance of a stage of the radio circuit. The sign of the reactance of the variable impedance element may be set such that it is the opposite to the sign of the combined reactance of the antenna and the stage of the radio circuit.

The operating frequency may be the frequency of operation of a receiver circuit for a particular channel. Alternatively, the operating frequency may be a frequency between the frequency of operation of the receiver circuit and the frequency of operation of a transmitter circuit. In this way the performance of a radio circuit that transmits and receives (that is, a transceiver) may be improved, and considered satisfactory, for both reception and transmission of signals.

In various embodiments the radio circuit may comprise a transmitter. The transmitter may be configured to generate a radio frequency signal having a guard time slot preceding a transmitter active time slot The controller may be further configured to provide a control signal to the at least one variable impedance element during the guard slot. The control signal may comprise a command for the at least one variable impedance element to set its impedance in order to at least partially match the output impedance of the transmitter to an apparent impedance of the antenna.

A guard slot is an inactive period of a time slot profile where the radio circuit is neither transmitting nor receiving signals. The guard time slot may be the time slot immediately preceding the transmitter signal time slot. The impedance of the variable impedance element may be set to match the transmitter output impedance to the apparent antenna impedance. In order to at least partially match two impedances, the controller may set the variable impedance element impedance so that the apparent antenna impedance has a voltage standing wave ratio (VSWR) lower than 2:1 or 3:1. impedance matching may be designed to yield an improved power transfer, linearity and/or efficiency of a transmitter or receiver of the radio circuit.

Alternatively, in order to at least partially match two impedances, the controller may set the variable impedance element impedance so that the apparent antenna impedance is a compromise between that required to match the impedance cf the antenna with the output impedance of the transmitter and that required to match the impedance of the antenna with an input impedance of the receiver.

In various embodiments the control signal may comprise a command for the at least one variable impedance element to set its impedance such that an apparent antenna impedance is the complex conjugate of an impedance between an output impedance of a transmitter and an optimum receive impedance value determined in accordance with the value of a received signal quality indicator.

The impedance of the variable impedance element (VIE) may be set to a compromise level. Setting the impedance of the VIE to a compromise level may be beneficial for radio circuits where a transmitter and receiver operate simultaneously. The impedance of the variable impedance element may be set at the arithmetic or geometric mean of (i) the transmitter output impedance at a transmit frequency; and (ii) an impedance determined in accordance with the received signal quality indicator at a receive frequency. The output impedance of the transmitter may be the output impedance of a power amplifier coupled to the at least one variable impedance element.

Alternatively, the impedance of the VIE may be set based on operation at an operating frequency that is neither the transmit frequency or receive frequency. For example, the impedance level of the VIE may be calculated using either the geometric or arithmetic mean of the receiver anc transmitter operating frequencies.

The impedance value for the VIE determined in accordance with the value of a received signal quality indicator may provide an apparent antenna reactance equal in magnitude and opposite in sign to the input reactance of the receive chain. The controller may also be configured to set the apparent impedance of the antenna to be the complex conjugate of the impedance of a stage of the radio circuit. That is, the controller may set the apparent value of the resistance to be equal to the resistance of the stage of the radio circuit, as well as setting the apparent value of reactance to be equal in magnitude but opposite in sign to the reactance of the stage of the radio circuit.

The controller may be configured to determine if the received signal quality indicator is greater or less than a threshold value. If the received signal quality indicator level is greater than the threshold value, the controller may be configured to provide a transmit control signal to the at least one variable impedance element. The transmit control signal may comprise a command to set the impedance of the at least one variable impedance element in order to at least partially match an output impedance of a transmitter. Alternatively, if the received signal quality indicator level is less than a threshold level, the controller may provide a receive control signal to the at least one variable impedance element. The receive control signal may comprise a command to set the impedance of the at least one variable impedance element in accordance with the value of the received signal quality indicator.

"Greater than" may be understood to comprise "greater than or equal to". Also, "less than" may be understood to comprise "less than or equal to".

The controller may be further configured to receive a first received signal quality indicator from the received signal quality indicator generator. The controller may provide a first signal to the at least one variable impedance element. The first signal may comprise a command for the at least one variable impedance element to modify its impedance by a first reactance value. The controller may receive a second received signal quality indicator from the received signal quality indicator generator. The controller may compare the first received signal quality indicator with the second received signal quality indicator.

If the second received signal quality indicator is greater than the first received signal quality indicator, then this may be interpreted as an indication that the impedance of the at least one variable impedance element is being changed in the correct direction (that is, either capacitively or inductively). In which case, the controller may provide a continue signal to the at least one variable impedance element. The continue signal may comprise a command to modify the impedance of the at least one variable impedance element by a continue reactance value. The continue reactance value may have the same sign of reactance as the first reactance value.

Alternatively, if the second received signal quality indicator is less than the first received signal quality indicator, then this may be interpreted as an indication that the impedance of the at least one variable impedance element is being changed in the incorrect direction (that is, either capacitively or inductively). In which case, the controller may provide a change signal to the at least one variable impedance element. The change signal may comprise a command to modify the impedance of the at least one variable impedance element by a change reactance value. The change reactance value may have the opposite sign of reactance to the first reactance value.

The controller may further perform another iteration of at least some of the above steps. The controller may consider the second received signal quality indicator received during the previous iteration to be the first received signal quality indicator for the next iteration.

Alternatively, after a number of iterations of this process, or if the second received signal quality indicator value is greater than a preset threshold, the process may be terminated or be suspended. Any of the reactance values may be set by a maximum step algorithm.

The controller may further comprise a memory containing preset values for the at least one variable impedance element corresponding to output impedances of a transmitter at a plurality of frequencies. The memory may contain preset values for the at least one variable impedance element corresponding to output impedances of the transmitter at a plurality of output power levels. These embodiments can be advantageous as they can reduce processing overhead where the impedance of the antenna can be considered as being relatively consistent with specific transmit parameters.

The controller may further comprise a memory containing preset values for the at least one variable impedance element corresponding to input impedances of a receiver at a plurality of frequencies. The impedances may be resistance values only or may be the complex impedance values having resistive and the reactive parts. The controller may set the resistance of the VIE according to a stored value of the resistance corresponding with a frequency of operating of the radio circuit. The stored value of the resistance may be such that the stored value of resistance plus the antenna resistance is closer to, cr broadly equal to, an input resistance of the receiver stage or an output resistance of the transmitter stage at the operating frequency.

Antenna reactance, on the other hand, may vary due to body de-tuning effects and so a reactance of the antenna may vary depending upon the environmental conditions of the antenna, such as its position and the material in its vicinity. The controller may be further configured to determine the impedance of the antenna at a desired transmit frequency by looking up the impedance of the antenna at the desired transmit frequency, or only the resistive part of the impedance at the desired transmit frequency, stored in the memory. The controller may provide a first signal to the at least one variable impedance element. The first signal may comprise a command for the at least one variable impedance element to set its impedance to an impedance value. The impedance value may account for the output impedance of the transmitter and the impedance of the antenna. The impedance value may modify the apparent antenna impedance value to be broadly equal to the complex conjugate of the output impedance of the transmitter operating at the desired frequency. The effect of the impedance of the VIE of such an embodiment is that it sets the apparent antenna impedance as the complex conjugate of the output impedance of the transmitter, thus providing a good impedance match between the antenna and the transmitter.

The controller may determine if the received signal quality indicator is less than a threshold value, and if the received signal quality indicator is less than the threshold value the controller may be configured to determine boundary conditions for the at least one variable impedance element. The threshold value may be -90 dBm, -100 dBm, -110 dBm. The boundary conditions may correspond to impedances of the at least one variable impedance element that would result in a satisfactory voltage standing wave ratio for the transmitter operating at the desired frequency. The satisfactory voltage standing wave ratio may be 1.5:1, 2:1, or 4:1, for example. The controller may iteratively modify the reactance of the at least one variable impedance element within the determined boundary conditions in order to improve the received signal quality indicator value.

The controller may determine the boundary conditions by performing a calculation. The calculation may be a function of the desired transmit frequency. Alternatively, the boundary conditions corresponding to a given voltage standing wave ratio for a desired transmit frequency may be predetermined. In this case the boundary levels may be stored in a look-up table in memory accessible by the controller. The controller may determine the boundary conditions by interrogating the memory.

The radio circuit may be configured to operate on a radio frequency signal having active time slots and guard time slots. In these embodiments the controller may be further configured to provide a signal to the at least one variable impedance element during a guard slot.

The controller may be configured to receive a received signal quality indicator obtained during an active time slot. An active time slot may be a transmitter active time slot, a receiver active time slot, or an active slot in which transmission or reception occurs simultaneously at different frequencies. In transceivers where reception (RX) and transmission (TX) occurs simultaneously, a pass-band of the at least one variable impedance element may be sufficiently wider than the highest TX/RX duplex frequency separation supported by the system. The bandwidth may be centred on a central RX or TX frequency of the respected frequency bands, or an average of the RX and TX frequencies.

A guard slot may be a period of inactivity of the RX and TX functions of a transceiver. Providing the signals to the VIE during a guard slot may be advantageous in order to avoid varying the performance of the antenna during an active slot. Variation in the performance of the antenna during an active slot may cause erroneous received signal quality indicator values to be produced, and/or alter the fidelity of the signal. The guard time slot may be the time slot immediately preceding the receiver signal time slot.

In the embodiments the received signal quality indicator is a receive signal strength indicator (RSSI), and the received signal quality indicator generator is a receive signal strength indicator generator.

The signal strength indicator generator is a metric readily available in known radio systems. Embodiments of the invention may therefore benefit from ease of integration with existing systems. The received signal quality indicator may be any known received signal quality indicator or metric available from the radio circuit.

In some embodiments the at least one variable impedance element is a member of a variable impedance network configured to suppress the frequency response of a fixed frequency signal. The at least one variable impedance element may be a single component or comprise a plurality of series and/or parallel matching branches of the matching network. Reference herein to changing the value of the VIE may refer to changing the value of any subcomponent of the VIE.

The variable impedance element (VIE) may also be described as a variable impedance network (VIN). The variable impedance network may also be referred to as a matching network. Components within the variable impedance network may be resistors, capacitors, inductors, transmission lines anc the like. The variable impedance network may comprise one or more components with variable impedance. Additionally, or alternatively, the variable impedance network may comprise one or more components with static impedance. The variable impedance network may selectively switch between various fixed impedance components in order to vary the impedance of the network.

Suppression of the fixed frequency signal may be achieved by configuring the variable impedance network to have a voltage standing wave ratio (VSWR) greater than 1:1 at the fixed frequency. Such a VSWR may be 7:1, 8:1, 9:1 or 10:1. The frequency responses suppressed may form a suppression band. The suppression band may be configured to coincide with the frequency of operation of a second antenna.

The second antenna may be housed near the antenna of the radio circuit to which the controller is in communication. The antenna of the radio circuit may not significantly interfere with the second antenna in such a configuration. The variable impedance network may be placed between the antenna and all of any receiver channel circuitry and/or transmitter channel circuitry. This can be advantageous as it can enable a radio circuit associated with a controller of an embodiment of the invention to be operated in proximity with other antennas without significantly degrading performance.

A single variable impedance network, also known as an adaptive matching network may be sufficient for the radio circuit. A single variable impedance network may be shared by all the transmit chains and receive chains in the radio circuit by placing the VIE at a common position close to the antenna port. This can reduce the number of components that are required to implement the radio circuit and therefore can occupy a reduced physical area/volume.

An additional benefit of a variable, or adaptive, impedance network connected at the front-end of the radio circuit, that is to say, directly to the antenna, or close to the antenna, is that the network may be tuned so as to reject out-of-band frequencies for the entire radio circuit. The impedance network may have a sufficiently wide band response to encompass all of the possible frequency bands used by the radio circuit. This approach is consistent with the "cognitive radio" concept wherein a wireless platform can be capable of altering radio parameters by monitoring its environmental conditions. Radio parameters comprise the operating band and the settings of the filter parameters. Environmental conditions comprise the available radio frequency spectrum and available radio access networks.

There may be provided a radio circuit comprising any controller disclosed herein, an antenna and at least one variable impedance element. The radio circuit may contain circuitry dedicated to receiving transmissions, and/or transmitting transmission. In such embodiments, the controller may comprise a received signal quality indicator generator and/or a variable impedance element.

Hardware implementation of the invention may be independent of the technology underlying its components. Existing technologies for variable antenna matching such as RF MEMS, SOS_CMOS, BST may be used.

The invention will now be further described by way of example only with reference to the accompanying drawings in which:

Figure 1 shows a radio circuit comprising the controller of an embodiment of the present invention;

Figure 2 shows an equivalent circuit diagram for the antenna and variable impedance network of Figure 1 at a specific operating frequency;

Figure 3 shows a series circuit model representing the antenna coupled to a variable impedance element and a terminating load impedance of the radio circuit;

Figure 4 shows a parallel circuit representing the antenna coupled to a variable impedance element;

Figure 5 shows a process according to an embodiment of the present invention;

Figure 6 shows a signal time slot profile suitable for use in a radio circuit such as that shown in Figure 1;

Figure 7 shows a transceiver radio circuit according to an embodiment of the present invention;

Figure 8 shows a signal time slot profile suitable for use in a radio circuit such as that shown in Figure 7;

Figure 9 shows a process according to another embodiment of the present invention;

Figure 10 shows a process according to a further embodiment of the present invention;

Figure 11 shows a profile of the mismatch loss of an antenna against the capacitance of a variable impedance element for a number of steps for two different impedance matching optimisation algorithms;

Figure 12 shows a process according to an embodiment of the present invention;

Figure 13 shows a number of possible circuit configurations for a variable impedance network;

Figure 14 shows a suppression notch in a signal at the GPS operating frequency formed by a simple LC network which may be a member of an adaptive matching network;

Figure 15 shows a suppression notch in a signal at the GPS operating frequency formed by an improved LC network providing insertion loss improvement at operating channel frequency;

Figure 16 shows a suppression notch in a signal at the GPS operating frequency formed by a further improved LC network providing improved GPS band suppression as well as reduced insertion loss at operating channel frequency; and

Figure 17 shows the use of multiple LC ladders between the antenna and a load of a radio circuit.

One or more embodiments of the invention relate to a controller for a radio circuit comprising a variable impedance element (VIE) to contribute to the input impedance of the radio circuit. The VIE is coupled between an antenna and a receiver stage of the radio circuit. A received signal quality indicator (RSQI) generator within the radio circuit provides an RSQI, which corresponds to the strength or quality of a signal received by the radio circuit, to the controller. An example of an RSQI is a received signal strength indicator (RSSI) that is known in the art. The controller is configured to receive the RSQI from the RSQI generator and to provide a control signal to the at least one variable impedance element. The control signal comprises a command to set the impedance of the variable impedance element in accordance with the value of the RSQI. This setting of impedance may be such that it causes the apparent antenna impedance to be closer to, or broadly equal to, the complex conjugate of the impedance of the input stage of a receiver of the radio circuit in order to improve signal reception at a desired frequency. In this way there is feedback between the RSQI value and the VIE reactance, and so the performance of the radio circuit can be improved.

A principle employed in seme embodiments is to change the value of at least one variable impedance element, also known as matching component, values in small steps (e.g. $\Delta C$, $\Delta L$) in order to modify the RSSI signal level. By doing so, the mismatch loss of the receive chain, and so the RSQI value, is changed in small steps ($\Delta RSQI$) and the value of the at least one variable impedance element can be se: such that satisfactory performance is achieved.

The controller can also be configured to take account of other circuit parameters when calculating the impedance for the variable impedance element, such as the impedance requirements of a transmitter of the radio circuit, in order to provide improved overall operation.

The controller can provide a flexible and easily implementable solution for improving the performance of the radio circuit, for example, during reception of RF signals without significantly degrading performance when transmitting RF signals, or vice versa.

While devices such as personal computers and cellular telephones increasingly require improved performance from their wireless terminals (like additional system support, extra frequency band coverage, etc.) it is desirable for the size of the form factors of the device not to increase significantly. However, in order to guarantee continued radio service quality, performance parameters (like receive sensitivity, transmit EVM, transmit linearity and efficiency etc.) should not be compromised by restrictions to the physical size of the device. Indeed, the same technical specifications are applied by cellular/wireless authorities (such as ETSI) independent of the internal architecture used and of the extra features (multiple bands, etc) supported by a system. Although, such specifications are commonly tested with reference to a 50 $\Omega$ source and load terminations via an RF connector interfaced with a radio circuit during system testing. In reality, the performance demands relating to the radiated power, such as transmit linearity, "total radiated power" (TRP) performances of the radio circuit evolve with the impedance of the antenna, which may be altered by its environment. It is found that the performance characteristics of real radio circuits diverge from those measured under test condition and may not be acceptable in use since such divergence may impact upon the perception of the user as to the general quality of service offered by the radio circuit.

Reducing the form factor of components, which may be desired for aesthetic or space saving requirements, tends to exacerbate the problems associated with poor signal quality. For this reason, the antenna can be considered a concern because of its relatively large dimensions compared to the other components, which can lead to temptation amongst system designers to constrict these dimensions.

Additionally, the number of separate antennas that can be provided for a system can also be limited by space constraints. Therefore, it may not be possible or desirable to use several different antennas for processing signals in different frequency bands to achieve better antenna matching over all of the desired frequency range. However, a single reduced scale wide-band antenna covering all the wireless radio bands of interest can lead to high impedance mismatches developing between the antenna and the radio circuit in some examples. These mismatches degrade the performance of the radio circuit and can be further exacerbated by the environmental effects such as body de-tuning, in which conductive objects in the vicinity of the antenna modify its impedance response.

Other antenna related topics comprise multiple-input and multiple-output (MIMO) and receive diversity techniques. One of the main objectives of these techniques is to increase the quality of the communication between the radio circuit and another node in the radio network with regard to metrics such as quality of service (QoS) or network bandwidth optimisation. However, these techniques tend to increase the cost of antenna units. Once such costs are incurred in order to improve communication quality, it may not be considered acceptable to lose such benefits due to poor antenna impedance matching.

Antenna mismatch can lead to the loss of established communication between a radio circuit and another wireless terminal. This phenomenon is sometimes called "call-drop". A weak signal close to the sensitivity level of the receiver can be further attenuated due to antenna impedance mismatch. After a call-drop the radio circuit needs to re-establish the cellular/wireless network synchronisation by using the synchronisation protocol of the respective cellular/wireless systems. This re-establishment requires several consecutive transmit and receive mode operations, and therefore causes a significant waste of energy.

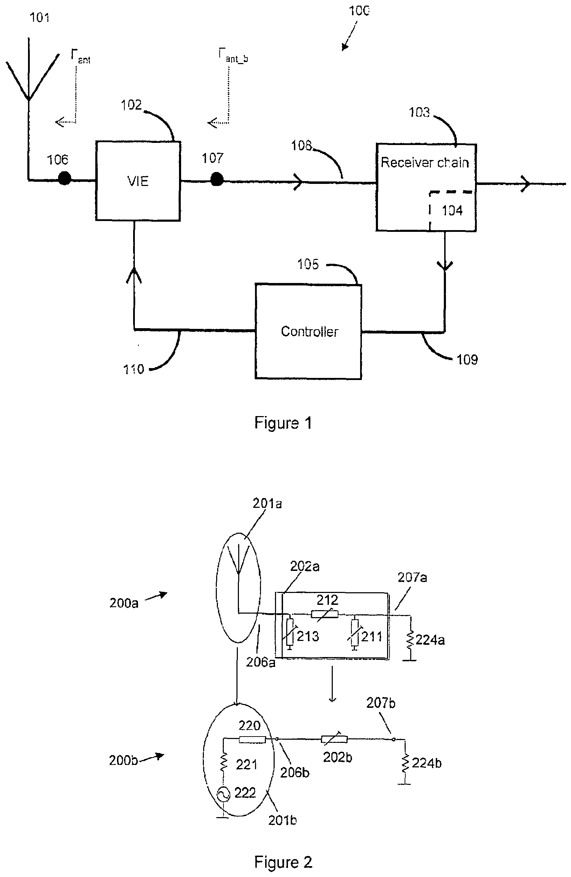

Figure 1 shows a controller 105 of an embodiment of the present invention schematically represented within a radio circuit 100. An antenna 101 provides a signal to a variable impedance element (VIE) 102, which in turn provides a signal to a receiver chain 103 of the radio circuit 100. The receiver chain 103 comprises a received signal quality indicator (RSQI) generator 104. An input of the controller 105 is coupled with an output of the RSQI generator 104 in order to receive RSQI signal 109. The controller 105 provides a control signal 110 to the VIE 102 in accordance with the RSQI signal 109. The control signal 110 provided by the controller 105 is configured such that it can instruct the VIE 102 to adopt an impedance that, when combined with the impedance of the antenna 101, improves the impedance matching of the radio circuit for improved signal reception.

Reference point 106 relates to a coupling between the antenna 101 and the VIE 102. The reflection coefficient $\Gamma_{ant}$ is determined at reference point 106 due to signals reflected from the antenna. Reference point 107 relates to a coupling between the VIE 102 and the receiver chain 103 of the radio circuit 100. The reflection coefficient $\Gamma_{ant\_b}$ is determined at reference point 107 due to signals reflected from the direction of the antenna. Figure 1 illustrates two reference points 106, 107. Equivalent positions within the circuit diagrams throughout this document are labelled with reference numerals X06 and X07.

The impedance of the VIE 102 combined with the impedance of the antenna is termed the apparent antenna impedance, which is the impedance experienced by the radio circuit at reference point 107. The reflection coefficient ($\Gamma_{ant\_b}$) seen at reference point 107 is a function of the matching element values in the VIE 102 as well as the antenna 102 mismatch ($\Gamma_{ant}$). The controller 105 may be configured to set the impedance of the VIE 102 so that the apparent antenna impedance is the complex conjugate of the required input impedance of the receiver 103 at the desired frequency. That is, VIE 102 sets the complex impedance of the antenna 101 to be the complex conjugate of the required input impedance of the receiver 103 at the desired frequency.

Therefore, the performance of the radio circuit 100 can be improved by setting the series and/or parallel reactances of the VIE 102 in this way.

Body-effect de-tuning is known to occur when the electromagnetic environment in the vicinity of an antenna is altered. An example of this is when a mobile phone antenna is brought near a human body. Antenna impedance variations due to body-effect de-tuning are generally limited to the reactive part of the antenna impedance for a properly designed antenna. The variation of the real part of the antenna impedance is relatively small compared to the variation of the reactive part for a properly designed antenna, as described in A. van Bezooijen et al., "RF-MEMS based adaptive antenna matching module", IEEE Radio Frequency Integrated Circuits Symposium, 2007. However, the reduced variation of the real part of the impedance due to body effect detuning does not mean that this resistive part is the same at all operating frequencies. A nominal input impedance for a receiver may be 50 ohms, but the resistance of the antenna may be 30 Ohm, for example, at a given operation frequency.

The static behaviour of the antenna resistance with regard to body effect detuning offer a simplification for the calculation of the required VIE resistance at a given frequency. A table of the resistive value versus frequency may be stored in a look-up table, either as parameters determined at production of the device based on lab measurements or as design parameters based on simulations.

In order to match the antenna impedance to an impedance of the receiver (which in general is 50 Ω), the controller must set the VIE so that the apparent antenna impedance is the complex conjugate of the receiver input impedance.

A received signal strength indicator (RSSI), which is a standardised metric readily available in many receiver systems, can be a suitable RSQI in some examples. The RSSI is regularly measured by almost all types of wireless platforms due to various system requirements, such as the need for adaptation of the receiver gain ($G_{RX}$) in response to the received signal strength measured at the antenna port. The RSSI signal is proportional to the in-phase signal and the quadratic-phase signal in the complex baseband domain:

$$RSSI \propto \sqrt{I_{RX}^2 + Q_{RX}^2}$$

Computation of the RSSI may be performed by a base-band processor in some systems. The same information may also be obtained in other systems using a power detector operating at RF (radio frequency) or IF (intermediate frequency). The definition of RSSI shown in the equation above is more commonly used for quadratic demodulation. However, the RSSI value may be an indication of the average power of the aerial signal monitored/received by the receiver irrespective of the demodulation architecture that is being used, be it quadratic or non-quadratic.

A common way to measure the RSSI level is by monitoring the base-band (BB) signal or the intermediate frequency (IF) signal as a complex waveform (I +jQ) and then calculating the average power of that complex waveform by averaging it over a time interval. This averaging may vary from one system to another depending on the time slot structure used. The RSSI is also a function of the receiver signal strength in dBrr ($S_{ant}$) at reference point 106, the receiver gain in dB ($G_{RX}$) under matched load conditions and the mismatch loss in dB ($Loss_{MM}$) of the antenna:

$$RSSI = S_{ant} - G_{RX} - Loss_{MM}$$

For a properly designed receiver the principal cause of the mismatch loss (if any) can be the antenna mismatch ($LOSS_{MM}$). $Loss_{MM}$ is related to the reflection coefficient, $\Gamma_{ant\_b}$, at reference point 107 towards the antenna as depicted in Figure 1, such that:

$$Loss_{MM} = -10\log\left[1 - \left|\Gamma_{ant\_b}\right|^2\right]$$

The antenna impedance at a fixed frequency, which may be the receiver operating frequency, can easily be represented by a series ($R_{ant} \pm X_{ant}$) or a parallel equivalent model. Similarly, a series reactance, ($\pm jX_M$) or a parallel susceptance ($\pm jB_M$) may represent the frequency behaviour of the variable impedance network within a certain frequency band around a receive channel frequency.

Figure 2 shows an example of the antenna and VIE of Figure 1 in greater detail. The top diagram 200a in Figure 2 shows the antenna 201a and VIE 202a coupled to a resistor 224a representing a radio circuit receiver load. In the top diagram 200a the antenna 201a is coupled via reference point 206a to the VIE 202a. VIE 202a also has a terminal coupled to reference point 207a, where an apparent antenna impedance can be measured.

VIE 202a is represented as a number of variable impedance elements 211, 212, 213, also referred to as a variable impedance network. One or more of these elements 211, 212, 213 may be a variable capacitor or variable inductor, for example.

The bottom diagram in Figure 2 shows an equivalent circuit 200b diagram for the top circuit 200a at a given frequency. In other words, the reactance 202b in series with the resistance 224b in the bottom circuit 200b is the equivalent series model of the network 202a in series with the terminating resistance 224a in the top circuit 200a. The value of the equivalent resistance 224b can be same or different than the value of the terminating resistance 224a.

The RF signal induced in the antenna is reoresented by a RF source 222 in the antenna 201b of equivalent circuit 200b. The antenna impedance at a fixed frequency can be represented by a series or parallel equivalent model composed of a resistor and a reactance (capacitor or inductor). In this example, the antenna impedance is shown as a resistor 221 and an impedance element 220 in series. Therefore, the antenna 201b is modelled as the RF source 222, resistor 221 and reactance element 220 in series between ground and the reference point 206b. Reactance element 220 can be either capacitive or inductive.

The VIE 202b is coupled between reference point 206b and reference point 207b. The variable impedance elements 211, 212, 213 of VIE 202a and the resistive element 224a are represented as a single variable impedance reactive element 202b in series with a resistive element 224b in equivalent circuit 200b. The series network constituted by 202b and 224b represents the equivalent model of the input impedance of a receiver of the radio circuit operating at a given frequency cascaded with the network 202a.

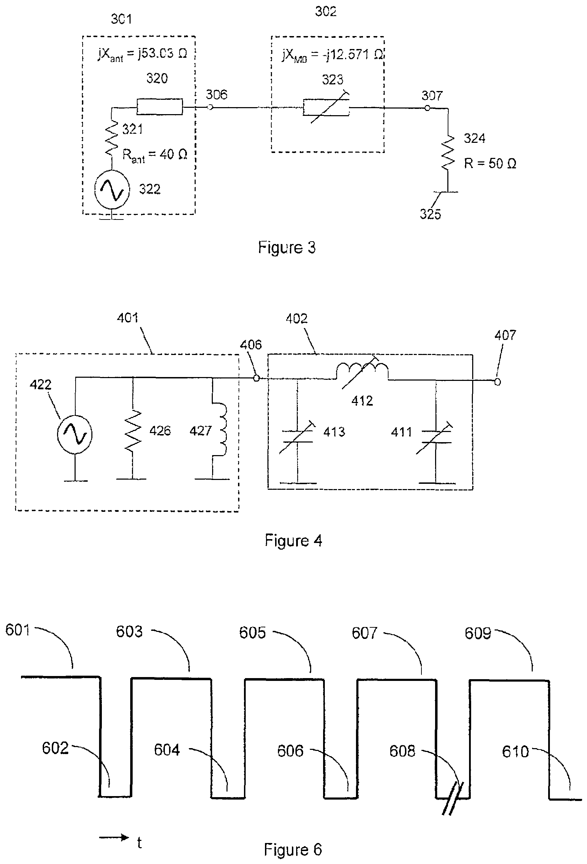

Figure 3 shows a schematic similar to the equivalent circuit 200b of Figure 2 in which the antenna 301 is represented by a series circuit containing a RF source 322, a source resistance 321 and a source reactance represented by an inductor 320 coupled between ground and reference point 306.

The reactive part of the equivalent serial impedance model of the circuit composed of a VIE terminated by the source or the load impedance of the radio circuit is represented by a single reactance 302. The reactance 302 is coupled between reference point 306 and reference point 307. Similarly the resistive element 324 of this model is coupled between reference point 307 and the ground 325. The reactive part of this model is represented as a capacitive reactance 323 in this example, but may also provide inductive reactance when needed.

Figure 3 will be described later with a specific example of how an embodiment of the invention may be used to control the VIE in order to match the antenna impedance to an input/output impedance of the radio circuit.

Figure 4 shows an alternative representation of an antenna 401, which is coupled to a VIE 402 at reference point 406. A second terminal of the VIE 402 is coupled to a reference point 407 which is terminated by a radio circuit terminating impedance (not shown in the Figure).

In Figure 4 the reactance of the antenna 401 is modelled as a parallel circuit operating at a given radio frequency. Antenna 401 is represented by an RF source 422, a resistor 426 and an inductor 427 connected between reference point 406 and the ground in this example.

The VIE 402, which may also be known as a variable impedance network, is itself modelled as a number of variable impedance elements 411, 412, 413 in order to conjugately match the impedance of the modelled antenna 401 to the radio circuit input/output impedance as seen at reference point 407. The VIE 402 shown in Figure 4 comprises a variable inductor 412 directly coupled between reference points 406 and 407 and two variable capacitors respectively connected to the terminals of the inductor and the ground. It will be appreciated that the VIE may have a different structure in other embodiments.

In various embodiments of the invention a controller is configured to undertake a number of steps in order to modify the reactance of the VIE that is cascaded with the radio circuit in response to the RSQI, as will be described below.

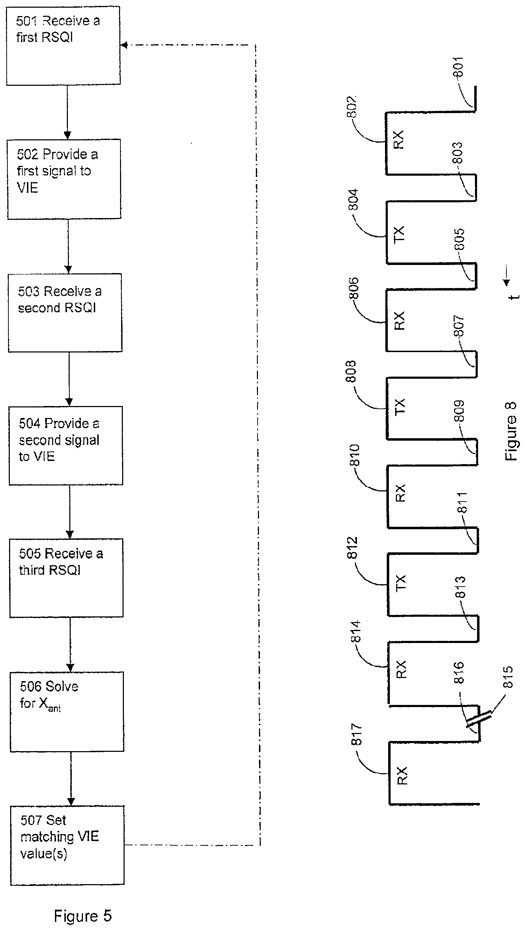

Figure 5 illustrates a process according to one embodiment of the invention. A first RSQI ($RSQI_1$) is received from the RSQI generator at step 501, and a first control signal is provided to at least one VIE at step 502. The first control signal comprises a command to modify the reactance of the at least one VIE by a first reactance value ($X_1$). At step 503, a second RSQI ($RSQI_2$) is received from the RSQI generator and at step 504, a second control signal is provided to the at least one VIE. The second signal comprises a command to modify the reactance of the at least one VIE by a second reactance value ($X_2$). The reactance quantities $X_1$ and $X_2$ can be the same, and equal to a change in reactance $\Delta X_M$ of the VIE 102. A third RSQI ($RSQI_3$) is received from the RSQI generator at step 505. The process of some embodiments determines, at step 506, the reactance ($X_{ant}$) of an antenna by solving a function:

$$X_{ant} = f\left(RSQI_1, RSQI_2, RSQI_3, X_1, X_2\right)$$

The process of Figure 5 provides, at step 507, a third signal to the at least one VIE. The third signal comprises a command to modify the impedance of the variable impedance element in accordance with the determined reactance of the antenna as well as the preset value of the antenna resistance value which is almost insensitive to body-detuning. Appropriate component values for the VIE can be computed using a commonly known matching network calculation procedure such that the antenna impedance is matched to the radio circuit input impedance.

In some examples, the environmental changes that cause body detuning effects are considered as a slowly varying phenomenon compared to the execution time of the process shown in Figure 5. As such, the impact cf these effects can be considered negligible during execution of the process of Figure 5 and therefore ignored.

After the completion of step 507 the process may be terminated or may be repeated from step 501, either immediately or after a period of time has elapsed. The process may be repeated in order to compensate for the potential impedance changes of the antenna.

The process of Figure 5 relates to how the component values of the VIE can be set as a matching network in accordance with the determined reactance ($X_{ant}$) of the antenna. In some examples, the precision of the process illustrated in Figure 5 can be related to the value of the resistance ($R_{ant}$) of the antenna that is used. However, the variation of $R_{ant}$ can be relatively small compared to the variation of $X_{ant}$ within the operating frequency band of the antenna and therefore only performing calculations for the value of $X_{ant}$ and not $R_{ant}$, can be considered acceptable.

**EP 2 557 688 B1**

In one embodiment, the function for $X_{ant}$ (shown above) can take the form of a differential equation or set of differential equations. The numerical solution of these differential equations provides the reactance value of the series (or the parallel) equivalent model of the antenna impedance at the operating frequency of a receiver chain in the radio circuit.

A number of differential equations for the system can be derived. The rate of change of the RSSI with respect to the change of the reactance $X_M$ of the VIE is proportional to the negative of the rate of change of the mismatch loss ($LOSS_{MM}$) with respect to the change of the reactance $X_M$ of the VIE:

$$RSSI' = \frac{RSSI}{\partial X_M} = -\frac{\partial Loss_{MM}}{\partial X_M}$$

The rate of change of the mismatch loss ($Loss_{MM}$) with respect to the change of the reactance $X_M$ of the VIE can be expanded in terms of the reflection coefficient ($\Gamma_{ant\_b}$) seen at the transceiver side:

$$\frac{\partial Loss_{MM}}{\partial X_M} = \frac{\partial Loss_{MM}}{\partial \left|\Gamma_{ant\_b}\right|^2} \cdot \frac{\partial \left|\Gamma_{ant\_b}\right|^2}{\partial X_M}$$

where

$$\left|\Gamma_{ant\_b}\right|^2 = \frac{(R_{ant} - R_{in\_rx})^2 + (X_{ant} + X_M)^2}{(R_{ant} + R_{in\_rx})^2 + (X_{ant} + X_M)^2} = \frac{(R_{ant} - 50)^2 + (X_{ant} + X_M)^2}{(R_{ant} + 50)^2 + (X_{ant} + X_M)^2}$$

$R_{ant}$ is a design parameter which has a generally negligible variation with respect to environmental changes like body-detuning. The factor of 50 in this example represents the real part of the equivalent serial impedance model of the VIE which is loaded/terminated by a radio circuit (receiver) input impedance. $R_{ant}$ may be considered as the design parameter. $R_{ant}$ can be stored in a look-up table as a function of operating frequency as it does not vary significantly with environmental changes.

The other terms in the rate of change of the mismatch loss with respect to the equivalent reactance $X_M$ of the serial equivalent model of the VIE terminated with a radio circuit input impedance equation (above) can be shown to be:

$$\frac{\partial Loss_{MM}}{\partial \left|\Gamma_{ant\_b}\right|^2} = -\frac{\partial Loss_{MM}}{\partial \left[1 - \left|\Gamma_{ant\_b}\right|^2\right]} \cdot \frac{\partial \left[1 - \left|\Gamma_{ant\_b}\right|^2\right]}{\partial \left|\Gamma_{ant\_b}\right|^2} = \frac{10}{\ln(10)} \cdot \frac{1}{\left[1 - \left|\Gamma_{ant\_b}\right|^2\right]} = \frac{10}{\ln(10)} \cdot \frac{\left[(R_{ant} + 50)^2 + (X_{ant} + X_M)^2\right]}{\left[4 \cdot R_{ant} \cdot 50\right]}$$

and

$$\frac{\partial \left|\Gamma_{ant\_b}\right|^2}{\partial X_M} = -\frac{8 \cdot R_{ant} \cdot 50 \cdot (X_{ant} + X_M)}{\left[(R_{ant} + 50)^2 + (X_{ant} + X_M)^2\right]^2}$$

The RSSI' can be expressed as an equation where all of the terms, with the exception of $X_{ant}$, are known:

$$RSSI' = \frac{\partial RSSI}{\partial X_M} = -\frac{\partial Loss_{MM}}{\partial X_M} = \lim_{\Delta X_M \to 0}\left[-\frac{\Delta Loss_{MM}}{\Delta X_M}\right] = -\frac{20}{\ln(10)} \cdot \frac{(X_{ant} + X_M)}{\left[(R_{ant} + 50)^2 + (X_{ant} + X_M)^2\right]}$$

Using values measured by the controller, the first differential of the RSSI with respect to the reactance may be taken to be:

$$\frac{\partial RSSI}{\partial X_M} = \frac{RSSI_2 - RSSI_1}{X_1}$$

Where $X = \Delta X_{M1}$, combining the above two equations gives:

$$\frac{RSSI_2 - RSSI_1}{\Delta X_M} = -\frac{20}{\ln 10} \cdot \frac{(X_{ant} + X_M)}{\left[(R_{ant} + 50)^2 + (X_{ant} + X_M)^2\right]}$$

such that all of the parameters are known apart from $X_{ant}$. This equation can be rearranged as a 2nd order polynomial which yields two possible solutions for the value of $X_{ant}$. In order to obtain an unambiguous value for $X_{ant}$, a second equation is required, allowing one of the two possible solutions of the second order polynomial to be discounted.

The second derivative of the RSSI along with the measured values for the RSSI can be used to determine which of the possible solutions to the above 2nd order polynomial is correct as follows:

$$RSSI'' = \frac{\partial^2 RSSI}{\partial X_M^2} = \lim_{\Delta X_M \to 0}\left[\frac{\Delta RSSI'}{\Delta X_M}\right] = \frac{20}{\ln 10} \cdot \frac{\left[(R_{ant} + 50)^2 - (X_{ant} + X_M)^2\right]}{\left[(R_{ant} + 50)^2 + (X_{ant} + X_M)^2\right]^2}$$

and

$$\frac{\partial^2 RSSI}{\partial X_M^2} = \left[\frac{(RSSI_3 - RSSI_2)/X_2 - (RSSI_2 - RSSI_1)/X_1}{(X_2 + X_1)/2}\right]$$

where $X_1 = \Delta X_{M1}$, $X_2 = \Delta X_{M2}$

This approach allows $X_{ant}$ to be calculated after only three measurements of the RSSI value ($RSSI_1$, $RSSI_2$, $RSSI_3$) and two variations of the VIE impedance ($X_1$, $X_2$). Such a calculation may be performed by a controller in accordance with the present invention as the values of all of these variables are available to it.

Since a differential equation by definition needs only a set of relative measurements, its accuracy is almost insensitive to systematic errors in the measurements. Hence, there may be no specific calibration requirement related to the use of this scheme.

In the equations referred to in this approach, the resistive part of the equivalent serial model representing VIE terminated/loaded with the radio circuit, is considered as a value that remains broadly constant (at 50 $\Omega$, in this example) for a given operating frequency. However, the equivalent resistance of the serial model can also be changed by changing the VIE reactance. In that case, the differential equations referred to above can be expanded to include the rate of the change of the RSSI and RSSI' values with respect to the change of the resistive part of the equivalent model as well as the change of its equivalent reactance.

Since the resistive part of the antenna impedance $R_{ant}$ is relatively insensitive to body-detuning effects compared to the reactive part ($X_{ant}$), the resistance value of the antenna at a range of desired frequencies can be stored in a look up table (LUT). The LUT can be generated either using design simulations or calibration/antenna measurements results and may be stored in a memory during manufacture. Alternatively, a single resistance value for the antenna could be assumed for all operating frequencies without significantly detracting from the performance of the circuit.

Returning to Figure 3, at a receiver operating frequency of 2110 MHz the antenna is modelled as a series circuit with a resistance of 40 $\Omega$ and an inductance of 4 nH.

The impedance of the modelled antenna 301 measured at reference point 306 is $Z_{ant0} = (40 + 53j)$ $\Omega$ at 2110 MHz. The subscript '0' here denotes the 0th step in a process. The initial setting of the variable impedance element is $C_{M0} = 6$ pF, which at 2110 MHz provides a reactance of $X_{M0} = -12.5715$ j$\Omega$. The impedance of the modelled antenna 301 measured at reference point 306 is $Z_{ant\_b0} = (40 + 53.03j)$ $\Omega$.

The partial impedance change afforded by the VIE 302 alters the impedance ($Z_{ant0}$) of the antenna 301 measured at reference point 306 to that of an apparent antenna reactance, $Z_{ant\_b0} = (40 + 41.4585)$ $\Omega$ at reference point 307 since $Z_{ant\_b} = Z_{ant} + jX_M$ in this model. This transformation of the impedance of the antenna to the apparent antenna impedance using a variable reactance/capacitor 323 with a value of 6 pF as the VIE 302 results in a measured reflection coefficient, $|\Gamma_{ant\_b0}| = 0.4224$ and mismatch loss, $Loss_{MM0} = 0.8533$ dB at reference point 307.

Modifying the impedance $X_M$ of the VIE 302 by 5 %, for example, gives $C_{M1} = 6.32$ pF, yielding an equivalent VIE 302 reactance, $X_{M1} = -11.943$ j$\Omega$. The subscript '1' here denotes values after the 1st iteration of altering the reactance of the VIE 302 has been performed. Now, with the updated equivalent reactance value $C_{M1} = 6.32$ pF, the apparent antenna reactance, $Z_{ant\_b1} = (40 + j41.0870)$ $\Omega$ is detected at reference point 307. This results in $|\Gamma_{ant\_b1}| = 0.4274$ and $Loss_{MM1} = 0.8761$ dB.

The antenna mismatch loss is intentionally changed by modifying the equivalent reactance of a VIE by a small increment, in order to determine the antenna matching gradient of the RSSI variation provoked by this change. It happens that the performance of the antenna has been degraded by increasing the value of $C_M$ by 5% as the value for the mismatch loss has increased in this example.

After the first iteration the change in reactance of the VIE can be calculated as $\Delta X_{M1} = X_{M1} - X_{MC}$. The values $X_{M0}$ and $X_{M1}$ may be determined by looking up the change of the equivilent capacitance value $C_{M0}$ and $C_{M1}$ in a look up table, or by use of the formula:

$$X_M = -\frac{1}{\omega C_M}$$

as is known in the art, where $\omega$ is angular frequency. If the equivalent reactance of the VIE model has a positive sign at an operating frequency, it can also be modelled by a single inductance at this frequency:

$$X_M = \omega L_M$$

For this example $\Delta C_{M1} = 0.32$ pF and $\Delta X_{M1} = -0.6286$ $\Omega$. $\Delta RSSI_1$ may be approximated to $-\Delta Loss_{MM1}$, which is:

$$\Delta Loss_{MM} = Loss_{MM1} - Loss_{MM0}$$

Therefore, $\Delta Loss_{MM} = 0.0228$ dB for $\Delta X_{M1} = -0.6286$ $\Omega$ in this numerical example.

As described previously:

$$RSSI'_1 = \lim_{\Delta X_M \to 0}\left[-\frac{\Delta Loss_{MM}}{\Delta X_M}\right] = -\frac{20}{\ln 10} \cdot \frac{(X_{ant} + X_M)}{[(R_{ant} + 50)^2 + (X_{ant} + X_M)^2]}$$

Substituting the obtained values of $\Delta Loss_{MM1}$ and $\Delta X_{M1}$ into the left hand side of this equation gives:

$$RSSI'_1 = \lim_{\Delta X_M \to 0}\left[-\frac{\Delta Loss_{MM1}}{\Delta X_{M1}}\right] = 0.02280 dB / -0.6286\Omega = -0.036276 dB\Omega^{-1}$$

Substituting values of $X_{M0}$ and $R_{ant}$ into the right hand side of the equation gives:

$$-0.036276 dB\Omega^{-1} = -\frac{20}{\ln 10} \cdot \frac{(X_{ant} - 12.5715)}{(40 + 50)^2 - (X_{ant} - 12.5715)^2]}$$

This equation can be rearranged to form a 2nd order polynomial in terms of $X_{ant}$ only. For this example, the two possible solutions are $X_{ant} = (53.3438, 211.2358)$ $\Omega$.

The controller could then try these solutions to see which produced the greater improvement in the mismatch loss value by monitoring the RSSI value in a real system. For this specific example, since 53.3438$\Omega$ is closer to the exact solution, the matching network values calculated for this impedance yields a better RSSI value than the false solution of 211.2358 $\Omega$.

Alternatively, the controller could be configured to perform another iteration and again modify the value of the VIE and measure the RSQI (or RSSI) value. In this numerical example, the VIE 302 equivalent reactance is changed by about another 5 % such that the corresponding capacitance value $C_{M2} = 6.67$ pF. For this example, $\Delta X_{M1} = \Delta X_{M2} = \Delta X_M$ and $\Delta X_{M2} = X_{M2} - X_{M1}$.

In this example, the equivalent reactance of the VIE 302 is now $X_{M2} = -j11,3144$ $\Omega$. The impedance measured at reference point 307 is now $Z_{ant\_b2} = (40 + j41.7157)$ $\Omega$. This results in $|\Gamma_{ant\_b2}| = 0.43244$, $LOSS_{MM2} = 0.8990$ dB.

Solving the first order differential equation for the change of the value of the variable capacitor from $C_{M1}$ to $C_{M2}$ gives $RSSI'_2 = -0.03664$ dB$\Omega^{-1}$.

As perviously described:

$$RSSI'' = \lim_{\Delta X_M \to 0}\left[\frac{\Delta RSSI'}{\Delta X_M}\right] = \frac{20}{\ln 10}\cdot\frac{\left[(R_{ant}+50)^2 - (X_{ant}+X_M)^2\right]}{\left[(R_{ant}+50)^2 + (X_{ant}+X_M)^2\right]^2}$$

Solving the left hand side of the equation using RSSI'$_1$, RSSI'$_2$ and $\Delta X_M$ gives:

$$RSSI' = \lim_{\Delta X_M \to 0}\left[\frac{\Delta RSSI'}{\Delta X_M}\right] = \left[\frac{RSSI'_2 - RSSI'_1}{\Delta X_{M_2}}\right] = \left[\frac{(-0.03664)-(-0.03627)}{-0.6286}\right] = 0.0005813\ dB^2\Omega^{-2}$$

Substituting the values of $R_{ant}$, $X_{M0}$ and the first of the possible $X_{ant}$ values previously found (53.3438) into the right hand side of the equation gives:

$$\frac{20}{\ln 10}\cdot\frac{\left[(40+50)^2 - (53.3438-12.5715)^2\right]}{\left[(40+50)^2 + (53.3438-12.5715)^2\right]^2} = 0.0005867\ dB^2\Omega^{-2}$$

Substituting the values of $R_{ant}$, $X_{M0}$ and the second of the possible $X_{ant}$ values previously found (211.2358) into the right hand side of the equation gives:

$$\frac{20}{\ln 10}\cdot\frac{\left[(40+50)^2 - (211.2358-12.5715)^2\right]}{\left[(40+50)^2 + (211.2358-12.5715)^2\right]^2} = -0.0001204\ dB^2\Omega^{-2}$$

As can be seen, the substituting the first value for $X_{ant} = j53.3438\ \Omega$ into the right hand side of the RSSI'' equation produces a value that is similar to the value obtained by solving the left hand side of the RSSI'' equation. Therefore, $X_{ant} = j53.3438\ \Omega$ may be accepted as being a good estimate of the value of the antenna reactance. The 'correct' value for the antenna reactance in this example is 53.03 j$\Omega$. The difference between the calculated and correct value is due to the calculation precision and the limitation of the limit function. By definition, $\Delta X_M$ should be infinitely small for the exact solution.

The second value for $X_{ant} = j211.2358\ \Omega$ may be rejected as a possible antenna reactance value. In some examples, whichever of the two possible values for the reactance of the antenna ($X_{ant}$) provides a value for RSSI'' which is closest to the value for RSSI'' that is determined using RSSI'$_1$, RSSI'$_2$ and $\Delta X_{M2}$ is considered the correct value for $X_{ant}$. In some examples, the value for RSSI'' determined from a possible value of the antenna reactance value must be close enough to the value for RSSI'' that is determined using RSSI'$_1$, RSSI'$_2$ and $\Delta X_{M2}$ for the value for $X_{ant}$ to be considered correct and used in subsequent processing. For example, the two values may have to be within a maximum absolute or relative threshold.

It will be appreciated that alternative steps may be taken to compare the results of the first and second differential equations.

Figure 6 shows a time slot profile with which some embodiments of the invention can operate. The time slot profile has a number of active time slots, which may be active receiver time slots 601, 603, 605, 607, 609, separated by time slots where the receiver is inactive. The inactive slots are also known as guard time slots 502, 604, 606, 610. The controller may implement the process shown in Figure 5 in line with this time slot profile as described below.

It is advantageous not to alter the reactance of the VIE during an active receiver time slot 601, 603, 605, 607, 609 as a sudden change during the active slots may perturb the receiver and so affect the received signal quality. However, it can be necessary to measure the RSQI value during an active receiver time slot 601, 603, 605, 507, 609.

The process of Figure 5 may involve:

receiving a first RSQI (RSQI$_1$) (at step 501) during receiver active time slot 601;
providing a first signal to a VIE (at step 502) during guard time slot 602;
receiving a second RSQI (RSQI$_2$) (at step 503) during receiver active time slot 603;
providing a second signal to the VIE (at step 504) during guard time slot 604;
receiving a third RSQI (RSQI$_3$) (at step 505) during receiver active time slot 605;
determining the reactance of the antenna (at step 506) before the end of guard time slot 606; and
providing a signal to set the reactance values of the VIE components according to the antenna reactance (at step 507) during guard time slot 606.

In various embodiments, step 507 also comprises setting the impedance of the VIE components according to a resistance value stored in a look-up table (LUT). The looking-up procedure can be conducted during step 506, in such embodiments. The resistance values may be stored in the look up table as a function of frequency.

During the subsequent receiver (RX) active time slot 607 the receiver will operate with the antenna impedance matched with the RX input stage impedance by the VIE 102 using the impedance calculated and set during stages 501-507.

The process may then be repeated after a given period of time 608. After this period of time 608 the process restarts and step 501 is performed during a later receiver active time slot 609. Step 502 is then performed during the following guard slot 610, and so forth. Alternatively, a periodic assessment of the RSS) can be made, and the process can be repeated when the assessment determines that the RSSI has deteriorated.

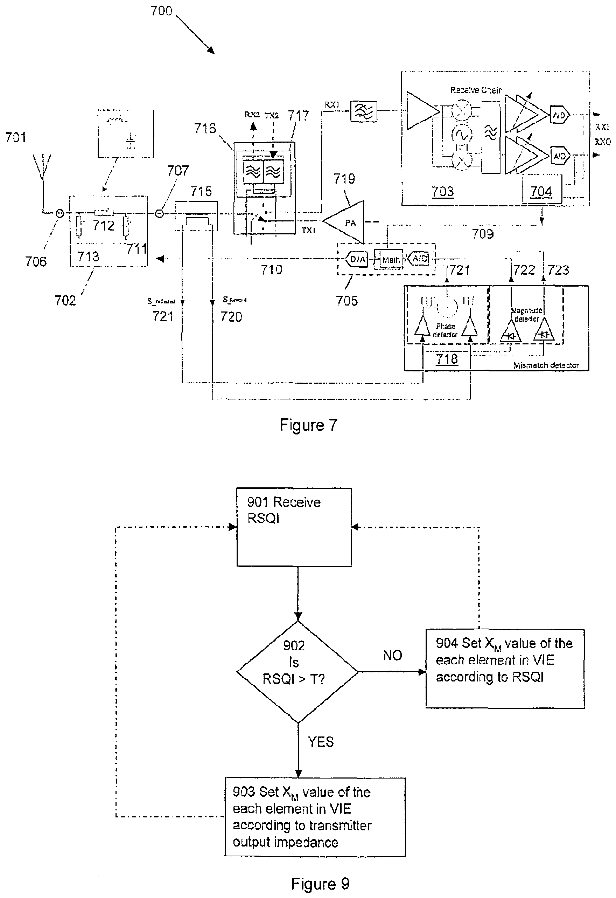

The controller according to some embodiments can be implemented in a circuit with multiple receiver (RX) chains or in a circuit with at least one receiver and at least one transmitter (TX) chain. A transceiver (RX/TX) circuit that comprises a controller 705 of an embodiment of the present invention is shown in Figure 7.

The antenna 701, receiver chain 703, and RSSI generator 704 of the radio circuit 700 are similar to the elements described in previous figures and will not be discussed further here. In accordance with previous figures, a reference point 706 is present at a connection between the VIE 702 and the antenna 701. The VIE 702 is coupled at a reference point 707 to the input stage of the receiver chains 703 and power amplifier (PA) 719 output stages of the transmitter chains of the radio circuit 700.

In this embodiment a number of additional components are present between the receiver chain 703 and the reference point 707. A directional coupler 715 is coupled between reference point 707 and a multiplexer 716, which is in turn coupled to both the receiver chain 703 and a power amplifier 719 (or other suitable component) of a transmitter chain. The multiplexer 716 can be used to couple either the receiver chain 703 or transmitter chain to the antenna 701 in order to allow signals to be received from the antenna 701 or transmitted to the antenna 701 during respective RX and TX active time slots for a time division duplex (TDD) operation. The same multiplexer can also be configured to couple the RX chain and the TX chain of a radio system designed for frequency division duplex (FDD) operation by using a frequency separation block 717 which can be part of a frequency duplexer form using band-pass filters. Alternatively, it can be in a diplexer form which has the functionality to distinguish the high-pass signals (TX or RX) then the low-pass signals (RX or TX) by making use of high-pass and low-pass filters. The multiplexer 716 may be controlled by the controller 705 in some embodiments.

During a TX active time slot, the power amplifier 719 output is exposed to the combined impedance of the antenna 701 and VIE 702 at reference point 707.

The variable impedance element 702 is used in both transmit and receive modes, and comprises a number of variable impedance elements 711, 712, 713. These elements 711, 712, 713 are configured in a similar way to those shown in VIE 202a in Figure 2. For a duplex system, the pass-band of the VIE 702 should be sufficiently wider than the highest RX/TX duplex frequency separation of the systems supported by the radio circuit 700.

A forward signal 720 and a reflected signal 721 are fed from the directional coupler 715 to a mismatch detector 718. The forward signal 720 is representative of the signal passing from the TX chain to the antenna during an active time slot. The reflected signal 721 is the signal that is reflected back from the antenna 701 to the transmitter during an active time slot due to, amongst other things, impedance mismatch between the antenna 701 and transmitter. Both the directional coupler 715 and mismatch detector 718 are known in the art, as is their use in matching impedance networks for the requirements of transmitter (TX) circuits. The mismatch detector 718 in the embodiment shown in Figure 7 provides the controller 705 with a signal 721 representative of the phase difference between the forward signal 721 and the reflected signal 720 as well as signals 722, 723 related to the amplitudes of the forward and reflected signals 720, 721. Alternatively, the controller 705 may provide a single signal in relation to the ratio between the reflected signal 721 amplitude and the forward signal 720 amplitude.

An output of the controller 705 is coupled to an input of the VIE 702 in order to provide a control signal 710 to the VIE 702. The controller is also coupled to receive an RSQI 709 from a RSQI generator 704 within the receiver chain. The controller 705 comprises an analogue to digital converter, which receives the three signals 721, 722, 723, or combinations thereof, from the mismatch detector 718 and provides digital signals to a maths processing block. The maths processing block also receives an RSQI signal 709 from the RSQI generator 704, and can process these four signals 721, 722, 723, 709 in order to determine how the parameters of the VIE 702 should be set. The number of the processed signals can also be three if a magnitude detector in mismatch detector 718 provides a relative signal as a ratio between the reflected signal 721 amplitude and the forward signal 720 amplitude.

In this example, the output of the controller 705 is a digital signal and it is converted to an analogue control signal 710 that is suitable for setting the VIE 702 by a digital to analogue converter. In other embodiments one or both of the digital to analogue converter and analogue to digital converters may not be required.

Impedance matching of the transmitter circuit may require different component values to those that may be required for impedance matching of the receiver circuit. The transmitter circuit impedance matching can be optimised such that the output impedance of the transmitter at reference point 707 is the complex conjugate of the apparent antenna impedance (also at reference point 707).

Satisfactory impedance matching between the power amplifier 719 of the TX circuit and the antenna 701 may be achieved, for example, by implementing the apparatus described in WO 2008/007330. Alternatively, values for the VIE 702 to improve the matching between the antenna and the TX circuit can be stored in a look-up table (LUT) as a function of operating frequency. The frequency of operation is already known by the radio circuit (by the base band processor for example), so the controller may use this information during its calculations. The controller 705 of this embodiment can then provide a control signal 710 to the VIE 702 according to the LUT value. This control signal 710 comprises a command for the reactance of the VIE 702 components to be set to the values in the LUT.

Antenna mismatch detection via a directional coupler 715, which may also be referred to as a signal splitter, is possible only for the transmitter mode operation and is not applicable to the receiver mode. The mismatch detection methods used for the transmit mode operations are not directly applicable for the receiver operations because of the opposite signal direction and relatively low signal levels which need to be detected. The directional coupler 715 and a mismatch detector 718 are used by the controller 705 in some embodiments to determine the required VIE 702 impedance in order to represent an impedance at reference point 707 that at least partially matches the output impedance of the transmitter 718. This can improve or maximise one or more of the performances of a transmitter for example power transfer, linearity, or power efficiency during transmission.

In this example, the multiplexer 716 connects either the receiver (RX) 703 or the power amplifier 719 of the transmitter (TX) to the antenna 701 according to a time slot profile. The time slot profile of Figure 6 may be used for such a transceiver where the active time slots 601, 603, 605, 607, 609 are used simultaneously for both RX and TX using frequency duplexing. Alternatively, the multiplexer may switch between only one of the receiver (RX) and the transmitter (TX) for a single time slot according to another time slot profile.

If a VIE 702 is placed at a common physical position shared by all the transmit and the receive chains, the performance of the receivers may be degraded when the VIE 702 is set by considering only the transmit performance constraints associated with the antenna mismatch measured at the transmit frequency. In that case, the each VIE 702 should be physically isolated from the receiver/receivers by putting it between the multiplexer 716 and the PA 719. "

Alternatively, a wide band VIE can be designed such that it covers at least the duplex frequency band of the system. That is, both TX and RX frequencies are simultaneously passed by the VIE. Alternatively, settings of the VIN can be altered to optimise RX and TX performances, in turn.

A second example time slot profile is shown in Figure 8. This time slot profile contains a number of guard time slots 301, 803, 805, 807, 809, 811, 813, 816. The active time slots are either RX active time slots 8C2, 806, 810, 814, 817 or TX active time slots 804, 808, 812. In various embodiments of the present invention the controller cf the radio circuit is configured to set the reactance of the VIE during a guard slot 803, 807, 811 to improve matching between the apparent antenna impedance and a transmitter circuit output in an immediately subsequent TX active time slot 804, 808, 812.

During the receiver active time slots 802, 806, 810, 814, 817 and their preceding guard slots 801, 805, 809, 813, 816 the controller may be configured to either provide a control signal to the VIE in accordance with the value of the RSQI or to perform the steps necessary to determine this control signal. For example, for a duplex RX/TX system the process of Figure 5 may be performed as follows:

receive a first RSQI ($RSQI_1$) (at step 501) during receiver active time slot 802;
provide a first signal to a VIE (at step 502) during guard time slot 805;
receive a second RSQI ($RSQI_2$) (at step 503) during receiver active time slot 806;
provide a second signal to the VIE (at step 504) during guard time slot 809;
receive a third RSQI ($RSQI_3$) (at step 505) during receiver active time slot 810;
determine the reactance of the antenna (at step 506) either in a guard slot 811, 813 or TX active time slot 812, before the end of guard time slot 313; and
provide a signal to set the reactance values of the VIE (at step 507), in some examples to set the reactance values of the matching branches of the VIE, according to the antenna impedance, during guard time slot 813.

In various embodiments, step 507 also comprises setting the impedance of the VIE components according to a resistance value stored in a look-up table (LUT). The looking-up procedure can be conducted during step 506, in such embodiments. The resistance values may be stored in the look up table as a function of frequency. The frequency corresponding to the looked up value may be the operating frequency of the transmitter, the receiver, or a frequency between the operating frequency of the transmitter and the receiver. During RX active time slot 814 and subsequent RX active time slots 817 the receiver will operate with the antenna reactance compensated for by the VIE using the impedance calculated and set according to an embodiment of the invention such as the process cf Figure 5.

Alternatively, the process described by Figure 5 may be repeated after a given period of time 815 or after a periodic assessment of the RSSI is made and finds that the RSQI has deteriorated to be inferior to a required level. In this case, the process restarts at step 501, which may be performed during RX active time slot 817.

Figure 9 illustrates a process according to an embodiment of the invention. The process involves controlling a duplex radio circuit. This process may be performed within a time slot profile such as that illustrated in Figure 8. Such an example is given below.

At step 901 an RSQI is received during an RX active time slot. At step 902 the process determines if the RSQI exceeds a preset threshold. If the threshold is exceeded then the system may be considered as operating in an environment where the received signal is strong enough for there not to be a received signal sensitivity issue. That is, the received signal can be processed satisfactorily. In this case, the process sends a signal to a VIE to set the impedance of the VIE ($X_M$) according to transmitter output impedance at step 903, as described previously. The VIE impedance will be set for subsequent TX active time slots and RX active time slots until the process is terminated, or may be repeated from step 901 after a predetermined interval of time.

If it is determined at step 902 that the threshold value is not exceeded then the process causes the reactance $X_M$ of each element of the VIE to be set according to the received RSQI of step 904. This step may comprise performing the process described in Figure 5 for the time slot profile shown in Figure 8. Step 501 may be omitted in this case as an equivalent step 901 has been performed.

In this way, the input impedance of the transceiver can be set with TX requirements if the quality of the received signal is considered acceptable, or may be set in accordance with the RX requirements if the quality of the received signal is considered inadequate.

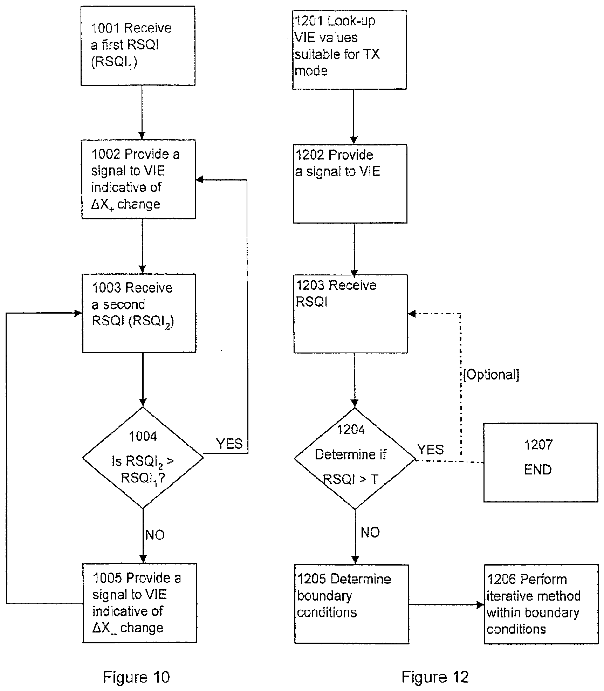

Figure 10 illustrates a process according to another embodiment of the invention. Figure 10 shows an iterative method for improving the receiver performance of a radio circuit that may be implemented in either a receiver circuit or a transceiver. At step 1001 a first RSQI measurement ($RSQI_1$) is received during an active receiver time slot. A control signal is then provided to a VIE at step 1002. The control signal comprises a command to change the impedance of the VIE by a value of reactance. Changing the impedance of the VIE may involve setting the equivalent series/parallel reactance of the VIE terminated by the radio circuit or the reactance of at least one matching branch of the VIE.

As this is the first iteration of step 1002, the reactance is changed by $\Delta X_{+1}$. At step 1003 a second RSQI measurement ($RSQI_2$) is received and $RSQI_1$ is compared with $RSQI_2$ at step 1004. If the RSQI value has improved, and $RSQI_2$ is greater than $RSQI_1$, then the process reverts to step 1002 and provides another signal to the VIE commanding the VIE to modify its reactance by a reactance value. As this is the second iteration of step 1002, the reactance is changed by $\Delta X_{+2}$. In this example, this reactance value $\Delta X_{+2}$ has the same sign of reactance as the reactance value $\Delta X_{+1}$ from the previous step 1002. $AX_{+2}$ is the same sign of reactance as $\Delta X_{+1}$ as the performance of the matching network was seen to improve after the reactance of the VIE was modified by $\Delta X_{+1}$. This method assumes that an additional change in the reactance with the same sign will continue to have a beneficial effect upon the RSQI.

The process may also return to step 1002 if $RSQI_1 = RSQI_2$.

Alternatively, if in the first iteration at step 1004 it is determined that the RSQI value has not improved between the first and second RSQI then the controller performs step 1005, instead of a second iteration of step 1002. In step 1005 the controller provides a signal to the VIE commanding the VIE to modify its reactance by a reactance value $\Delta X_-$, with the opposite sign of reactance as that provided in step 1002 (in this example, $\Delta X_+$). For example, if step 1002 increased the reactance ($\Delta X_+$) of the VIE 702, then step 1005 would reduce the reactance ($\Delta X_-$) of the VIE. After step 1005 has been performed the process returns to step 1003 for a second iteration. The reactance value modification referred to above can be applied to a single or multiple elements of a VIE at the same time.

For both of the possible outcomes of step 1004, for the next iteration (when the process moves on to step 1002 or 1005) the controller will consider the $RSQI_2$ from the previous iteration to be the first RSQI value ($RSQI_1$) of that iteration.

The controller of this embodiment may set the reactance of the VIE so as to match the impedance at the input of the receiver, or output of the transmitter, with the impedance of the antenna. The resistive part of the antenna impedance may be determined by interrogated a bok-up table comprising stored resistance values as a function of frequency and retrieving a value for the resistance at an operating frequency cf the system.

The magnitude of the change of the reactance value ($\Delta X_+$, $\Delta X_-$) can be a constant or varied throughout the various steps in the process. In order to reduce the convergence time of this process, instead of using a constant step size for the change in reactance $\Delta X_M$ between the consecutive iterations, one of the known variable-step maximisation algorithms can also be used. For example,
variable step maximisation algorithm 1:

$$X_M^{k+1} = X_M^k \pm f'(X_M^k) \quad ;$$

or variable step maximisation algorithm 2:

$$X_M^{k+1} = X_M^k \pm \frac{f'(X_M^k)}{f''(X_M^k)}.$$

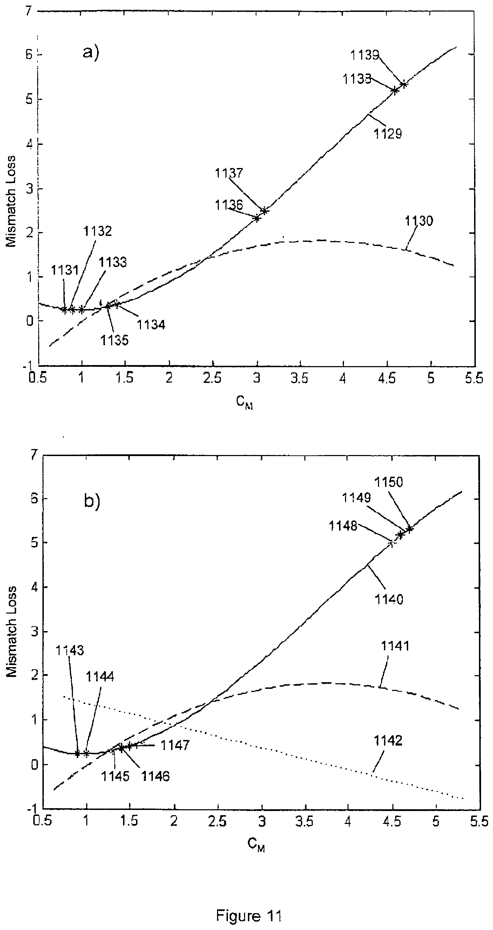

When using the algorithms 1 and 2 the mismatch loss (Loss$_{MM}$) can evolve as a function of reactance of a variable element in a VIE, The reactance can be modelled by a capacitance ($C_M$) of the VIE. Figure 11a shows the mismatch loss function 1129 against the change of the value of a capacitance in a VIE obtained using algorithm 1 (with a minus sign separating the terms on the right hand side of the equation) for a specific example. As discussed previously, Loss$_{MM}$ is a controlling factor for the RSSI. In this example the mismatch loss is minimised when the VIE adopts a capacitance of 1 pF, which means that RSSI is maximised for a given environmental condition at a given frequency. The first derivative of the mismatch loss with respect to the capacitance of the VIE is shown with a dashed line 1130 in Figure 11a. By definition, the derivative function helps to determine the step size and the sign of the capacitance increment.

Figure 11b shows the mismatch loss function 1140 against the same capacitance of the VIE referred to in Figure 11a, obtained using algorithm 2 (also with a minus sign separating the terms on the right hand side of the equation). It can be seen that both algorithms provide a swift convergence of the VIE capacitance to an optimised value. The first derivative of the mismatch loss with respect to the capacitance of the VIE is shown with a dashed line 1141 in Figure 11b and the second derivative is shown with a dotted line 1142.

The RSQI variations induced can be monitored as a function of the impedance by manipulating the value of the VIE in small steps. In both Figure 11a and 11b, an initial capacitance of 4.7 pF for the VIE is used and these measurements are shown with reference numbers 1139, 1150. Points 1138, 1149 show measurements taken for the VIE having a capacitance of 4.6 pF (that is, the capacitance has been modified by 0.1 p= as an example) in order to determine the first differential of the reactance of the antenna. It will be appreciated that having two measurements provides the information necessary to determine the rate of change of the mismatch loss with respect to capacitance change.

Further adjustments of the capacitance of the VIE are made in accordance with the above variable-step maximisation algorithms. The subsequent measurements in Figure 11a are shown with reference numbers 1131 to 1137 and the subsequent measurements in Figure 11b are shown with reference numbers 1143 to 1148.

It can be seen from Figure 11a that algorithm 1 requires eight iterations of changing the reactance value to converge on the optimal value for $C_M$ of 1 pF Figure 11b illustrates that algorithm 2 requires seven iterations to converge on the optimised value of 1 pF.

In some embodiments of the invention, the controller is configured to use algorithm 1 or 2 in order to set the reactance value required to modify the reactance of a VIE between each iteration. This process may further involve the processor performing additional steps of modifying the reactance of the VIE by a small value of reactance (such as 0.1 pF, as in at least some of the examples described above in relation to Figures 11a and 11b) and measuring the RSQI after modifying the reactance by the small reactance value. After this additional step has been performed, the controller would have the two measurements that are required to calculate the first derivative of the mismatch loss and therefore calculate the next change in reactance value using algorithm 1.

In order to set the reactance value for the next iteration using algorithm 2, the controller can further modify the reactance of the VIE by another small reactance value and again measure the RSQI and so obtain the necessary three measurements for calculating the second derivative of the mismatch loss.

Figure 12 shows a process according to another embodiment of the invention. This process uses a memory with LUT look-up values for a VIE impedance at various transmitter operating frequencies stored within it. These values can either be obtained by performing an antenna mismatch measurement during a TX operation, or can be stored as an antenna design parameter during production of the antenna.

At step 1201, the process looks-up a value for a VIE to suit the transmitter frequency and provides a signal, at step 1202, to the VIE curing a guard time slot to apply the looked-up value for the VIE. The value for the VIE can describe both the resistive and capacitive parts of the apparent impedance.

It will be apparent to those skilled in the art that other methods for determining a suitable VIE impedance for the transmitter are well known.

At step 1203, a RSQI measured during a RX active time slot is received and the process determines if the RSQI exceeds a preset threshold at step 1204. If the RSOI value does meet the threshold then sensitivity is not considered an issue for the receiver, and the transceiver can use the present value of the VIE impedance for both TX and RX active time slots. In this case the process may end, at step 1207, or optionally return to step 1203 after a period of time has elapsed.

If the RSQI does not exceed the threshold value then a set of boundary conditions $X_{M1}$, $X_{M2}$ for the reactance $X_M$ cf the VIE are determined at step 1205. The boundary conditions may be for the equivalent reactance of the complete VIE, or for a single or plural matching elements/branches of the VIE. These boundary values can either be independent values for each matching element/branch, or some or all of them can be defined as a function of the other matching element values or boundaries. These boundary conditions can be calculated such that a targeted VSWR value at the operating transmit frequency is not exceeded while changing the VIE element values in order to improve the VSWR value at the operating receive frequency.

For example, the boundary conditions may be set as a lower limit $X_{M1}$ and an upper limit $X_{M2}$ for the reactance $X_M$ of the VIE. These limits can be set so as to ensure that a voltage standing wave ratio (VSWR) for an antenna and the VIE together is not exceeded and also set so that maximum and minimum component value limits are not exceeded for given VIE components. The VSWR is a proxy measure for the maximum acceptable impedance mismatch between the antenna and TX circuitry. A high VSWR can degrade the performance of the transmitter in terms of power efficiency or linearity, for example. A suitable limit for the VSWR may be 4:1, 3:1, 2:1 or 1.5:1. Boundary conditions $X_{M1}$, $X_{M2}$ for the reactance $X_M$ of the VIE may be determined using from preceding antenna impedance measurements performed during TX operation. Alternatively, the VIE reactances $X_{M1}$, $X_{M2}$ that correspond to the VSWR limits may be determined by looking-up the values $X_{M1}$, $X_{M2}$ for a given frequency of operation stored in a LUT. The values can be set in the LUT at manufacture as empirically derived values or by a calibration experiment. The process may also determine whether the RSQI merely meets a preset threshold instead of exceeding the threshold.

After the reactances $X_{M1}$. $X_{M2}$ for the VIE that correspond to the VSWR limited have been determined, an iterative method of modifying the reactance of the VIE and receiving the RSQI value is performed at step 1206. The method of step 1206 can be similar to the process described in Figure 10. However, in this example the reactance value of the VIE can be adjusted so as not to exceed the limits $X_{M1}$, $X_{M2}$. If the processing of step 1206 reaches one of these boundary conditions, it may either end the process or reverse the polarity of the change in reactance being applied. For example, if a boundary condition is reached whilst applying additional capacitive impedance in order to improve the RSQI value, the process may command the VIE to instead apply an opposite reactance change (inductive reactance). Performing an iterative method within these limits allows the controller to improve the received signal quality whilst simultaneously maintaining suitable conditions for a transmitter circuit. The controller may reiterate the process from step 1203 after a predetermined interval of time has elapsed to ensure that the RSQI value has not deteriorated.

One advantage of embodiments of the present invention is that it allows a single variable impedance network (VIN), which may also be referred to as matching networks, to be coupled between the antenna and a plurality of transceiver chains. Prior art solutions may require the VIN to be placed between the antenna and a transmitter, but not between the antenna and a receiver. Additionally, prior art solutions may require one dedicated VIN for each power amplifier (PA) or each transmitter chain. In an alternative embodiment, step 1201 of Figure 12 can be replaced by initially performing the process illustrated in Figure 5 or 10 to determine the reactance of the antenna in transmit mode. If such a process is employed it can be expected that the system will already be operating with an improved apparent antenna impedance when step 1202 is initiated. In some embodiments the process of Figures 5 or 10 will modify the reactance of several components of the VIN and the method of step 1206 of Figure 12 may be applied to a subset of the components within the VIN.

The present invention can provide flexibility to balance the different objectives of a transceiver radio circuit depending on environmental conditions and the requirements of the wireless systems supported. The VIN may be capable of adaptation for either filtering (such as low pass, band pass, high pass, and notch filtering) or for impedance matching purposes or both simultaneously by performing partial matching as well as the partial filtering. This flexibility is because a VIE used in accordance with embodiments of the present invention need not be placed at a common physical position for all the receivers and the transmitters in a wireless platform, contrary to prior art solutions. One of the advantages of an adaptive filtering VIN in a wireless application is that, because of its adaptability, bandwidth versus selectivity requirements of a VIN may be less stringent than those for a static front-end filter, which must cover the entire system bandwidth while providing static frequency rejection. In other words, adaptive filters do not need to have the same level of selectivity compared to their static counterparts. As such, the VIN can provide rejection of a given frequency using a number of LC components, which may be impractical for a static LC filter because of their higher selectivity requirements in order to guarantee the same rejection while having a wider pass-band.

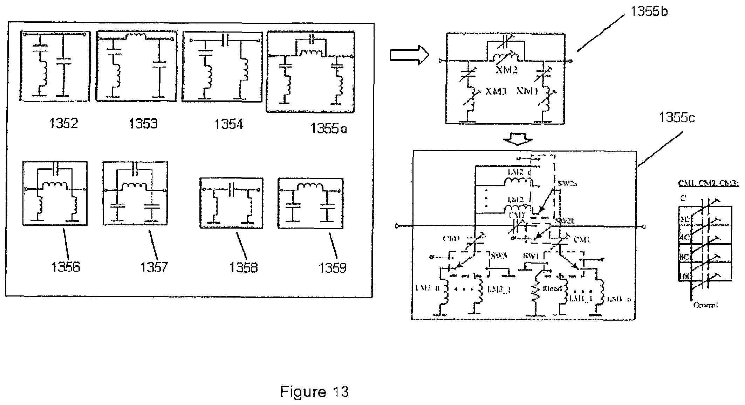

A number of example impedance and filter network configurations 1352-1359 are shown in Figure 13, one or more, or all, of the components in these networks 1352-1359 may have controllable, variable, values. These components may represent the at least one VIE, or VIN, referred to above.

Circuit 1352 shows an LC network with an input coupled to an output. The input and output are coupled to the ground through two channels. One channel comprises a capacitor and an inductor in series. The second channel comprises a capacitor.

Circuit 1353 shows an LC network with an input coupled to an output via an inductor. The input is coupled to the ground through a capacitor and an inductor in series. The output is coupled to the ground through a capacitor.

Circuit 1354 shows an LC network with an input coupled to an output via a capacitor. The input is coupled to the ground through a capacitor and an inductor in series. The output is coupled to the ground through an inductor.

Circuit 1355a shows an LC network with an input coupled to an output via a parallel arrangement of a capacitor and an inductor. The input is coupled to the ground through a capacitor and an inductor in series. The output is coupled to the ground through a capacitor and an inductor in series.

Circuit 1356 shows an LC network with an input coupled to an output via a parallel arrangement of a capacitor and an inductor. The input and the output are both coupled to the ground by respective inductors.

Circuit 1357 shows an LC network with an input coupled to an output via a parallel arrangement of a capacitor and an inductor. The input and the output are both coupled to the ground by respective capacitors.

Circuit 1358 shows an LC network with an input coupled to an output via a capacitor. The input and the output are both coupled to the ground by respective inductors.

Circuit 1359 shows an LC network with an input coupled tc an output via an inductor. The input and the output are both coupled to the ground by respective capacitors.

Circuit 1355b shows an example of circuit 1355a where the components are explicitly depicted as being variable value components. Figure 1355b provides a general description allowing all of the possible configurations shown in circuits 1352-1359.

It will be appreciated that elements of any of the circuits may be capable of being short circuited or open circuited.

Circuit 1355c provides additional information that can be used to implement this impedance network in some embodiments. This circuit is an example for the implementation of the network 1355b with some components open or short circuited.

An open and short circuit possibility for each of the branches as well as a constant resistive load ($R_{load}$) selection, for instance 50 Ω, via SW1 can enable automatic calibration features, such as S (scattering) parameter calibration. This calibration can be performed using circuit 1355c as VIE 702 in a system such as that illustrated in Figure 7. A forward path signal at any frequency is emitted towards the antenna by at least one of the transmit chain in this system. The open, short and load Impedances may be presented by the circuit 1355c at the reference point 707 during such a calibration. In this case the gain of the PA 719, or its input drive level can be backed-off such that the PA 719 is protected against the reflections produced during the open and short circuit calibration. After the calibration has been performed, the antenna impedance can be measured by configuring the circuit 1355c in such a way that the series branch is by-passed (an input to output short circuit) by SW2a and shunt branches are open circuited by SW1 and SW3. This circuit modification allows for the direct measurement of the antenna impedance. In this circuit it is assumed that the capacitors CM1 and CM3 can take sufficiently high capacitance value in order to operate in a by-pass mode, if needed. Alternatively, a by-pass switch for CM1 and another for CM3 can be used in parallel to these components.

Alternatively, the circuit 1355c can be configured to preset values and the standalone antenna impedance is calculated by using the apparent impedance measured and the preset values (known parameters) of the circuit 1355c. These calibrations and mismatch measurements are performed during the guard slots and this process can also be applied for the antenna impedance/mismatch measurement at operating receive frequencies as long as the transmit chain is capable of generate a signal at the receive frequency.

These calibrations/measurements may be performed as a one-off factory calibration or can be dynamically implemented by a controller operating on a communication systems which tolerate weak signal emission during guard slots.

An additional path exists between the input and the output in circuit 1355c. In this path a single pole switch is provided with the central terminal coupled to the output, the central terminal of the switch may be optionally coupled by the switch either directly to the input or to the input via an inductor.

In circuit 1355c, a central terminal of another single pole switch is coupled between the capacitor and inductor connected in series to the input. The central terminal of the switch may be optionally coupled by the switch either directly to ground or to ground via an inductor.

In circuit 1355c, a central terminal of further single pole switch is coupled between the capacitor and inductor connected in series to the output. The central terminal of the switch may be optionally coupled by the switch either directly to ground or to ground via an inductor.

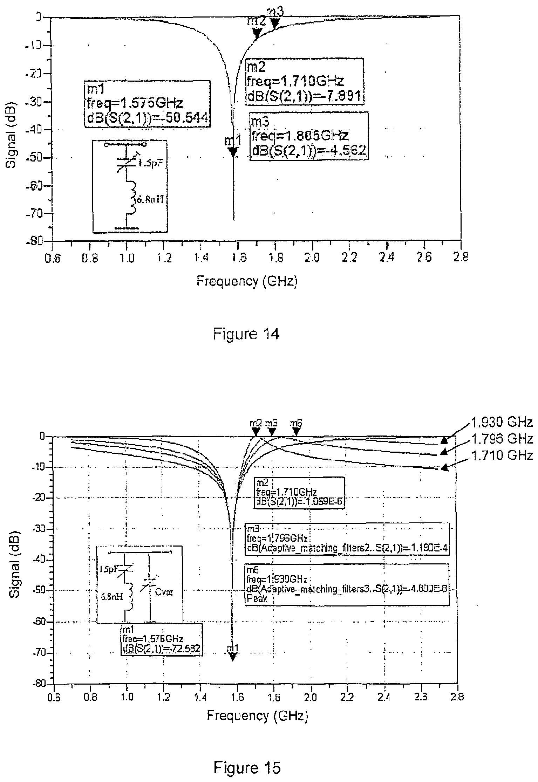

As will be described with reference to Figure 14, embodiments of the controller are configured for use in radio circuits that are situated in close proximity to a GPS receiver. In this situation a radio circuit of the prior art may be a source of interference for the GPS system. This is a particular problem for GPS systems, as the signal received by GPS receiver units is a comparatively weak RF signal. Radio circuits operating in close proximity to GPS systems may have insufficient post-power amplifier selectivity at the operating frequency of the GPS system and cause substantial interference with the GPS system.

Figure 14 plots the signal transfer function against frequency of an impedance network comprising an input, coupled to the antenna, and an output, coupled to a transceiver (RX/TX). The network has a variable capacitor (set at 1.5 pF) and a fixed 6.8 nH inductor connected in series between the input and the ground in order to offer post-power amplifier selectivity to the radio circuit. The network produces an LC notch at 1.575 GHz where the LC network allows approximately -70 dB of the signal transmittance that is observed at 1 GHz. However, the attenuation of the signal at the operating frequencies of 1.710 GHz (m2) and 1.805 GHz (m3) is undesirably high.

The performance cf an improved impedance network, similar to the circuit 1352 in Figure 13, is shown in Figure 15. The circuit comprises a parallel arrangement of a variable capacitor and a series circuit comprising a variable capacitor (set at 1.5 pF) and a fixed 6.8 nH inductor connected between the input/output and ground. An objective of this design is to keep the notch frequency at the GPS operating frequency, which is fixed by the series resonant circuit (1.5 pF, 6.8 nH), and simultaneously eliminate the equivalent reactance (which is inductive above the resonant frequency but capacitive below the resonant frequency) of the series resonant circuit. The elimination is achieved by trimming the parallel capacitor ($C_{var}$) value in order to improve (reduce) the insertion loss of the circuit 1352 at a specific operating frequency. The operating frequency is shown as frequency m2 in Figure 15. Since the channel frequency of this system (for instance cellular/wireless system) can be another frequency, such as m3 or m6, rather than m2, the capacitance of $C_{var}$ may be altered to accommodate the new frequency. Ideal values for the variable capacitor operating at a number of different frequencies are:

$C_{var}$ = 8.45 pF for m2 at 1.71 GHz;
$C_{var}$ = 5.02 pF for m3 at 1.796 GHz; and
$C_{var}$ = 3 pF for m6 at 1.93 GHz.

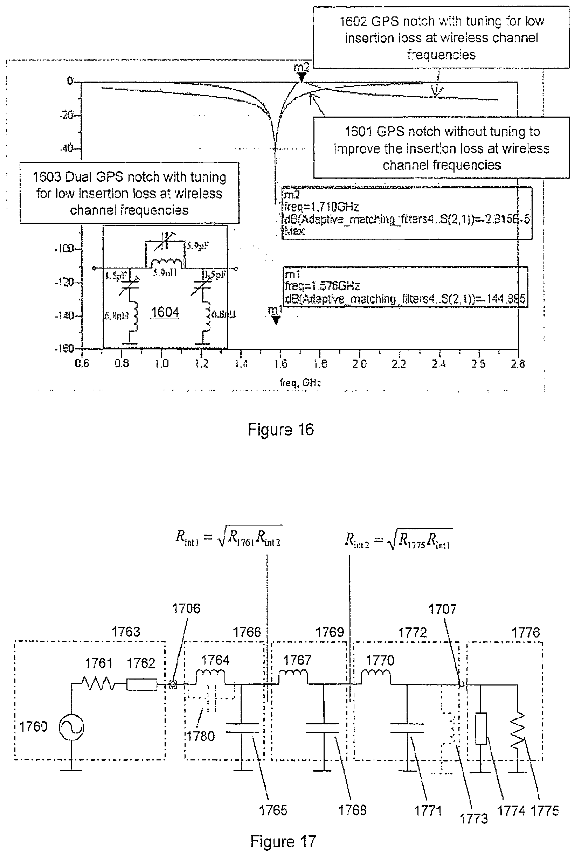

Figure 16 shows a comparison of the performance of the various impedance networks.

Curve 1601 corresponds to the graph depicted in Figure 14, where the series circuit had no compensation capacitor. The sole feature of the curve being a GPS notch. The insertion loss around the wireless operating frequency m2 is unacceptable.

Curve 1602 corresponds to the curve tuned for low insertion loss at 1.71 GHz using a variable capacitor in parallel with the series circuit, with $C_{var}$= 8.45 pF.

Curve 1603 relates to the response of the network circuit 1604 shown in Figure 16. Circuit 1604 give a higher GPS rejection than the previously described circuits. A second rejection notch is shown at around 0.85 GHz

The circuit 1604 comprises an LC network with an input coupled to an output via a parallel arrangement of a variable capacitor (set at 5.9 pF) and a 5.9 nH inductor. The input is coupled to the ground through a variable capacitor (set at 1.5 pF) and a 6.8 nH inductor in series. The output is coupled to the ground through a variable capacitor (set at 1.5 pF) and a 6.8 nH inductor in series.

A second rejection notch is shown at around 0.85 GHz on curve 1603. Circuit 1604 nas an impedance correction network, which provides reactance elimination at the operating wireless frequency in between the two notches.

The exact inductance values required may not be available in the adaptive network. In that case, the most appropriate inductance value that is available in the network can be selected. The capacitor in parallel with the inductor in the series branch may then be tuned. Similarly, the capacitors in series to the inductors in the parallel branches may also be tuned in order to get the required reactance value at the operating frequency. This approach uses the knowledge that the granularity of the variable capacitors are in general better than the granularity of the variable inductors.

Figure 17 illustrates a commonly used wideband matching network whereby the complete matching network is divided into a cascade of LC ladders 1766, 1769, 1772. These sections are also called "L sections" 1766, 1769, 1772. In Figure 17 each LC ladder comprises an inductor 1764, 1767, 1770 coupled between the respective inputs and the outputs of each ladder, and a capacitor 1765, 1768, 1771 coupled between the respective outputs and the ground.

Each L section 1766, 1769, 1772 transfers its source or load impedance to another, intermediate, impedance. These intermediate impedances are calculated by taking the geometric mean of the source/load impedances of the neighbouring L sections. The matching network in Figure 17 has three L sections 1766, 1769, 1772 which result in two intermediate impedances between L sections 1766 and 1769, and between L sections 1769 and 1772, respectively. The resistances measured at these two intersections are labelled $R_{int1}$, corresponding to the resistance measured between L sections 1766 and 1769, and $R_{int2}$, corresponding to the resistance measured between L sections 1769 and 1772.

$$R_{int\,2} = \sqrt{R_{1775}R_{int\,1}}\;;$$

and

$$R_{int\,1} = \sqrt{R_{1761}R_{int\,2}}\;.$$

The example matching method described here follows the following methodology:

- The real part of the source impedance is matched to the real part of the load impedance (or vice-versa)
- The reactive part 1762 of the source impedance is combined with the reactance of the closest matching element 1764. Similarly, the equivalent parallel susceptance 1774 of the load impedance 1776 is combined with the susceptance of capacitor 1771.

For instance, if the series reactance 1762 of the block 1763 representing the antenna has a reactance value of - j10 Ω, and the required reactance value for inductor 1764 in the adjacent LC ladder section 1766 according to the first step is + j10 Ω, then the final value required for the inductor 1764 is + j20 Ω. However, if the reactance value of the series reactance 1762 is + j30 Ω then the inductor 1764 should present a reactance of - j20 Ω in order to obtain an overall reactance of + j10 Ω. In order that both capacitive and inductive reactance can be provided, a series capacitor 1780 (dashed line) in parallel with the inductor 1764, and similarly a shunt inductor 1773 (dashed line) in parallel with a capacitor 1771, are provided in this embodiment of the circuit.

Nevertheless, these two elements are either not initially required, as explained in the first example given above, or they can be eliminated by tuning other component values such that they are not need for inductor 1773, nor the capacitor 1780 (shown in dashed lines) in parallel to inductor 1764. The minimum possible quality factor (Q) value is calculated by using the equation:

$$Q = \sqrt{\frac{RL}{RS} - 1} \; ;$$

where RL is the resistance of the load 1775, RS is the resistance of the source 1761, and RL > RS.

The same Q value is applied during the calculation of the component values. Finally, the reactive parts of the source and the load impedances are combined with the closest elements to these ports.

By considering different impedance network structures during the circuit design, for instance including some additional network branches, a variable impedance network can be used for the purpose adaptive front-end filtering for both transmit and receive chains of the supported systems when used in combination with embodiments of the present invention.

Prior art solutions do not address the antenna impedance matching issues experienced by a radio circuit during the receive mode operation. The majority of effort in this field has been directed towards improving the matching conditions in transmit mode only, especially for the highest transmit power levels, due to the fact that its impact on power amplifier performance (efficiency, linearity, power accuracy, etc.) is directly proportional to the output power. Unfortunately, it is likely that the transmitter power would need to be maximised at the same time that the detected signal strength is weakest. The prior art mismatch detection methods used for the transmit mode operations are not directly applicable for the receiver operations because of the opposite signal direction and the relatively low signal intensity which needs to be detected. Moreover, for prior solutions if the antenna impedance is matched to the centre of the operating TX frequency, the antenna impedance matching at the operating RX frequency degraded. This is especially notable for narrow band matching networks used in most of the prior art solutions.

In many cases, multiple transmitter circuits, also known as transmit chains, are needed by prior art systems in order to support different wireless platforms and different frequency bands. This is mainly due to the limitations of the performance of PAs over large frequency ranges. Using one common power amplifier for numerous transmitter channels or system standards may be impractical and possibly undesirable due to the performance limitations that it imparts.

The front-end of the radio circuit, specifically the placing and operation of a variable impedance network, may be significantly simplified compared to the prior art solutions due to the incorporation of an embodiment of the present invention. The availability of antenna mismatch information during receive mode operations as well as transmit mode operations can allow embodiments of the present invention to address requirements for both the transmit and receive modes simultaneously by centring the VIN at a common frequency between the RX and TX frequencies.

Such flexibilities can enable the VIN to be placed anywhere between the antenna 701 and the multiplexer 716 (Fig.7) whereas the prior art solutions may not be implemented in this way. As a result of this simplicity, the adaptive filtering feature can be integrated into a single adaptive network rendering the multiple VINs required by prior art solutions redundant

A problem remains for receiver or transceiver systems as matching the antenna impedance to the transmitter output impedance tends to have a deleterious effect on the matching between the antenna and the receiver circuitry. Embodiments of the present invention can improve the impedance matching performance for a receiver circuit.

Embodiments of the invention can reduce redundant circuit elements such as variable impedance elements, which must be duplicated for prior art systems comprising multiple transceiver chains. Whatever the front-end architecture is, irrespective of the number of TX and RX chains, the same variable impedance network can be used without need for duplication when used in conjunction with the controller of embodiments of the present invention. Neither, in this case, is any kind of additional RF switching network required in order tc share one common matching block between different transmit line-ups, which may be deemed to be a considerable problem with prior art solutions due to, for example, the inefficiency or reduction in flexibility that implementing such architecture imparts.

Embodiments of the invention can directly influence the choice of front-end architecture and hardware implementation of a wireless platforms in which they are to be implemented. The implementation of a common adaptive matching network adjacent to the antenna port can be is independent of the access method used by the wireless platform, such as TDMA or FDMA, and also independent of the duplexing methods used, for example TDD or FDD.

Embodiments of the invention may provide efficient and adaptable antenna impedance matching and also allow for improved power transfer efficiency. Embodiments of the invention may also provide an apparatus that implements many of the tenants of the "green radio" concept, such as improved power transfer efficiency, linearity and power accuracy of the transmit chain. All of these characteristics can be highly influenced by antenna impedance mismatches.

**Claims**

1. A controller (105) for a radio circuit (100), the radio circuit (100) comprising at least one variable impedance element (102) coupled between an antenna (101) and a received signal strength indicator generator (104), wherein the controller (105) is configured to:

receive (501) a first received signal strength indicator from the received signal strength indicator generator (104);
provide (502) a first signal to the at least one variable impedance element (102), the first signal comprising a command to modify the reactance of the at least one variable impedance element (102) by a first reactance value;
receive (503) a second received signal strength indicator from the received signal strength indicator generator (104);
provide (504) a second signal to the at least one variable impedance element (102), the second signal comprising a command to modify the reactance of the at least one variable impedance element (102) by a second reactance value;
receive (505) a third received signal strength indicator from the received signal strength indicator generator (104);
calculate (506) a reactance of the antenna (101) using a differential equation after the three measurements of the received signal strength indicator and the two variations of the reactance of the variable impedance element (102), by:

(i) rearranging:

$$\frac{RSSI_2 - RSSI_1}{X_1} = -\frac{20}{\ln 10} \cdot \frac{(X_{ant} + X_M)}{\left[(R_{ant} + F)^2 + (X_{ant} + X_M)^2\right]}$$

as a 2nd order polynomial to provide two possible solutions for the reactance of the antenna, $X_{ant}$, where:

$RSSI_1$ is the first received signal strength indicator,
$RSSI_2$ is the second received signal strength indicator,
$X_1$ is the first reactance value change,
$X_M$ is the initial value of the least one variable impedance element before the change by the first reactance value,
$R_{ant}$ is a design parameter, and
F is a factor representing a real part of an equivalent series impedance model of the VIE which is loaded/terminated by the radio circuit input impedance;

(ii) solving

$$\left[\frac{(RSSI_3 - RSSI_2)/X_2 - (RSSI_2 - RSSI_1)/X_1}{(X_2 + X_1)/2}\right]$$

to produce a first quotient, RSSI",
where

$RSSI_3$ is the second received signal strength indicator, and
$X_2$ is the second reactance value change;

(iii) substituting the two possible values for the reactance of the antenna $X_{ant}$ calculated in (i), into the equation:

$$\frac{20}{\ln 10} \cdot \frac{\left[(R_{ant} + F)^2 - (X_{ant} + X_M)^2\right]}{\left[(R_{ant} + F)^2 + (X_{ant} + X_M)^2\right]^2}$$

to produce respective second and third quotients,
(iv) selecting one of the possible values for the reactance of the antenna $X_{ant}$ from (i) by determining which of the second and third quotients matches the first quotient; and

provide a control signal (100) to the at least one variable impedance element (102), the control signal (100) comprising a command to set (507) the impedance of the variable impedance element (102) in accordance with the determined reactance of the antenna (101).

2. The controller (705) of claim 1 wherein the radio circuit (700) comprises a transmitter configured to generate a radio frequency signal having a guard time slot (803, 807, 811) preceding a transmitter active time slot (804, 808, 812), and wherein the controller (705) is further configured to provide a control signal (710) to the at least one variable impedance element (702) during the guard slot (803, 807, 811), the control signal (710) comprising a command for the at least one variable impedance element (702) to set its impedance in order to at least partially match the output impedance of the transmitter to an apparent impedance of the antenna (701).

3. The controller (705) of claim 2 wherein the control signal (710) comprises a command for the at least one variable impedance element (702) to set its impedance such that an apparent impedance of the antenna (701) is the complex conjugate of an impedance between an output impedance of a transmitter and an impedance level determined responsive to the value of a received signal strength indicator at a frequency between operating frequencies of the transmitter and receiver.

4. The controller (705) of claim 2 further configured to:

receive (901) a received signal strength indicator from the received signal strength indicator generator (104);
determine (902) if the received signal strength indicator is greater or less than a threshold value; and

if the received signal strength indicator level is greater than the threshold value, provide (903) a transmit control signal (710) to the at least one variable impedance element (702), the transmit control signal (710) comprising a command to set the impedance of the at least one variable impedance element (702) in order to at least partially match an output impedance of a transmitter, or
if the received signal strength indicator level is less than a threshold level, provide (904) a receive control signal (710) to the at least one variable impedance element (702), the receive control signal (710) comprising a command to set the impedance of the at least one variable impedance element (702) responsive to the value of the received signal strength indicator.

5. The controller (705) of any preceding claim further comprising a memory containing preset values for the at least one variable impedance element (702) corresponding to:

output impedances of a transmitter stage at a plurality of frequencies; and/or
input impedances of a receiver stage at a plurality of frequencies,
wherein the controller is configured to set the reactance of the VIE in accordance with a preset value of a variable impedance element (702) corresponding to the frequency of operation of the radio circuit.

6. The controller of claim 5 further configured to:

(i) determine an impedance of the antenna (701) at a desired transmitter frequency by looking up (1201) the impedance of the antenna and/or the transmitter output impedance at the desired transmitter frequency stored in the memory;

(ii) provide (1202) a first signal to the at least one variable impedance element (702), the first signal comprising a command for the at least one variable impedance element (702) to set its impedance to an impedance value, the impedance value broadly equal to the complex conjugate of the output impedance of the transmitter operating at the desired frequency minus the impedance of the antenna (701) at the desired frequency;

(iii) receive (1203) a received signal strength indicator from the received signal strength indicator generator (704);

(iv) determine (1204) if the received signal strength indicator is less than a threshold value, and if the received signal strength indicator is less than the threshold value the controller is configured to:

(iv.a) determine (1205) boundary conditions for the at least one variable impedance element (702), the boundary conditions corresponding to impedances of the at least one variable impedance element (702) that would result in a given voltage standing wave ratio for the transmitter operating at the desired frequency, and

(iv.b) to improve the received signal strength indicator value by iteratively modifying (1206) the reactance of the at least one variable impedance element (702) within the determined boundary conditions.

7. The controller (105) of any preceding claim wherein the radio circuit (100) is configured to operate on a radio frequency signal having active time slots (601, 603, 605, 607, 609) and guard time slots (602, 604, 606, 610); and wherein the controller (105) is further configured to provide a control signal (110) to the at least one variable impedance element (102) during a guard slot (602, 604, 606, 610).

8. The controller (105) of any preceding claim wherein the at least one variable impedance element is configured to suppress the frequency response of a fixed frequency signal.

9. A radio circuit (100) comprising the controller (105) of any preceding claim, an antenna (101) and at least one variable impedance element (102).

**Patentansprüche**

1. Ein Kontroller (105) für einen Funkschaltkreis (100), der Funkschaltkreis (100) aufweisend zumindest ein variables Impedanzelement (102), welches gekoppelt ist zwischen einer Antenne (101) und einem Empfangssignal Stärkenindikator Generator (104), wobei der Kontroller (105) konfiguriert ist zum:

Empfangen (501) eines ersten Empfangssignal Stärkenindikators von dem Empfangssignal Stärkenindikator Generator (104);

Bereitstellen (502) eines ersten Signals zu dem zumindest einen variablen Impedanzelement (102), wobei das erste Signal einen Befehl aufweist zum Modifizieren der Reaktanz von dem zumindest einen variablen Impedanzelement (102) durch einen ersten Reaktanzwert;

Empfangen (503) eines zweiten Empfangssignal Stärkenindikators von dem Empfangssignal Stärkenindikator Generator (104);

Bereitstellen (504) eines zweiten Signals zu dem zumindest einen variablen Impedanzelement (102), wobei das zweite Signal einen Befehl aufweist zum Modifizieren der Reaktanz von dem zumindest einen variablen Impedanzelement (102) durch einen zweiten Reaktanzwert;

Empfangen (505) eines dritten Empfangssignal Stärkenindikators von dem Empfangssignal Stärkenindikator Generator (104);

Berechnen (506) einer Reaktanz von der Antenne (101) unter Verwendung einer Differentialgleichung nach den drei Messungen von dem Empfangssignal Stärkenindikator und den zwei Variationen von der Reaktanz von dem variablen Impedanzelement (102), durch:

(i) neu Anordnen:

$$\frac{RSSI_2 - RSSI_1}{X_1} = -\frac{20}{\ln 10} \cdot \frac{(X_{ant} + X_M)}{\left[(R_{ant} + F)^2 + (X_{ant} + X_M)^2\right]}$$

als ein zweite Ordnung Polynom zum Bereitstellen von zwei möglichen Lösungen für die Reaktanz von der Antenne, $X_{ant}$, wobei:

RSSI$_1$ der erste Empfangssignal Stärkenindikator ist,

RSSI$_2$ der zweite Empfangssignal Stärkenindikator ist,

X$_1$ die erste Reaktanzwert Änderung ist,

X$_M$ der Anfangswert von dem zumindest einen variablen Impedanzelement ist vor der Änderung durch den ersten Reaktanzwert,

R$_{ant}$ ein Designparameter ist, und

F ein Faktor ist, welcher repräsentiert einen realen Teil von einem äquivalenten Serien Impedanz Model von dem variablen Impedanzelement, welches belastet wird/abgeschlossen wird durch die Funkschaltkreis Eingangsimpedanz;

(ii) Lösen

$$\left[ \frac{(RSSI_3 - RSSI_2)/X_2 - (RSSI_2 - RSSI_1)/X_1}{(X_2 + X_1)/2} \right]$$

zum Produzieren eines ersten Quotienten, "RSSI", wobei

RSSI$_3$ der zweite Empfangssignal Stärkenindikator ist, und

X$_2$ die zweite Reaktanzwert Änderung ist;

(iii) Substituieren der zwei möglichen Werte für die Reaktanz von der Antenne X$_{ant}$, welche in (i) bestimmt wurden, in die Gleichung:

$$\frac{20}{\ln 10} \cdot \frac{\left[ (R_{ant} + F)^2 - (X_{ant} + X_M)^2 \right]}{\left[ (R_{ant} + F)^2 + (X_{ant} + X_M)^2 \right]^2}$$

zum Produzieren eines entsprechenden zweiten Quotienten und eines entsprechenden dritten Quotienten,

(iv) Selektieren von einem von den möglichen Werten für die Reaktanz von der Antenne X$_{ant}$ von (i) durch bestimmen, welcher von dem zweiten Quotienten und von dem dritten Quotienten mit dem ersten Quotienten übereinstimmt; und

Bereitstellen eines Steuersignals (100) zu dem zumindest einen variablen Impedanzelement (102), wobei das Steuersignal (100) aufweist einen Befehl zum Einstellen (507) der Impedanz von dem variablen Impedanzelement (102) in Übereistimmung mit der bestimmten Reaktanz von der Antenne (101).

2. Der Kontroller (705) gemäß Anspruch 1, wobei der Funkschaltkreis (700) aufweist einen Sender, welcher konfiguriert ist zum Generieren eines Funkfrequenz Signals, welches einen Schutz Zeitslot (803, 807, 811) hat, der vorrausgeht einem Sender aktiven Zeitslot (804, 808, 812), und

wobei der Kontroller (705) ferner konfiguriert ist zum Bereitstellen eines Steuersignals (710) zu dem zumindest einen variablen Impedanzelement (702) während des Schutzslots (803, 807, 811), wobei das Steuersignal (710) aufweist einen Befehl für das zumindest eine variable Impedanzelement (702) zum Einstellen seiner Impedanz, um zumindest teilweise anzupassen die Ausgangsimpedanz von dem Sender einer scheinbaren Impedanz von der Antenne (701).

3. Der Kontroller (705) gemäß Anspruch 2, wobei das Steuersignal (710) aufweist einen Befehl für das zumindest eine variable Impedanzelement (702) zum Einstellen seiner Impedanz, sodass eine scheinbare Impedanz von der Antenne (701) die komplex Konjugierte ist von einer Impedanz zwischen einer Ausgangsimpedanz von einem Sender und einem Impendanzlevel, welches reagierend zu dem Wert von einem Empfangssignal Stärkenindikator bestimmt wird bei einer Frequenz zwischen Betriebsfrequenzen von dem Sender und Empfänger.

4. Der Kontroller (705) gemäß Anspruch 2, ferner konfiguriert zum:

Empfangen (901) eines Empfangssignal Stärkenindikators von dem Empfangssignal Stärkenindikator Generator (104);

Bestimmen (902),

ob der Empfangssignal Stärkenindikator größer oder kleiner als ein Schwellenwert ist; und

wenn das Empfangssignal Stärkenindikator Level größer ist als der Schwellenwert, Bereitstellen (903) eines Sende Steuersignals (710) zu dem zumindest einen variablen Impedanzelement (702), wobei das Sende Steuersignal (710) aufweist einen Befehl zum Einstellen der Impedanz von dem zumindest einen variablen Impedanzelement (702), um zumindest teilweise anzupassen zu eine Ausgangsimpedanz von einem Sender, oder

wenn das Empfangssignal Stärkenindikator Level kleiner ist als ein Schwellenlevel, Bereitstellen (904) eines Empfang Steuersignals (710) zu dem zumindest einen Impedanzelement (702), wobei das Empfang Steuersignal (710) aufweist einen Befehl zum Einstellen der Impedanz von dem zumindest einen variablen Impedanzelement (702), reagierend zu dem Wert von dem Empfangssignal Stärkenindikator.

5. Der Kontroller (705) gemäß irgendeinem vorherigen Anspruch ferner aufweisend einen Speicher, welcher enthält vorher eingestellte Werte für das zumindest eine variable Impedanzelement (702), korrespondierend zu:

Ausgangsimpedanzen von einer Senderstufe bei einer Mehrzahl von Frequenzen; und/oder

Eingangsimpedanzen von einer Empfängerstufe bei einer Mehrzahl von Frequenzen, wobei der Kontroller konfiguriert ist zum Einstellen der Reaktanz von dem variablen Impedanzelement in Übereinstimmung mit dem vorher eingestellten Wert von einem variablen Impedanzelement (702), welches korrespondiert zu der Betriebsfrequenz von dem Funkschaltkreis.

6. Der Kontroller gemäß Anspruch 5 ferner konfiguriert zum:

(i) Bestimmen einer Impedanz einer Antenne (701) bei einer gewünschten Senderfrequenz durch Nachsehen (1201) der Impedanz von der Antenne und/oder der Sender Ausgangsimpedanz bei der gewünschten Senderfrequenz, welche gespeichert ist in dem Speicher;

(ii) Bereitstellen (1202) eines ersten Signals zu dem zumindest einen variablen Impedanzelement (702), wobei das erste Signal aufweist einen Befehl für das zumindest eine variable Impedanzelement (702) zum Einstellen seiner Impedanz zu einem Impedanzwert, wobei der Impedanzwert allgemein gleich zu der komplex Konjugierten von der Ausgangsimpedanz von dem Sender ist, operierend bei der gewünschten Frequenz, minus der Impedanz von der Antenne (701) bei der gewünschten Frequenz;

(iii) Empfangen (1203) eines Empfangssignal Stärkenindikators von dem Empfangssignal Stärkenindikator Generator (704);

(iv) Bestimmen (1204), ob der Empfangssignal Stärkenindikator kleiner ist als ein Schwellenwert, und wenn der Empfangssignal Stärkenindikator kleiner ist als der Schwellenwert, dann ist der Kontroller konfiguriert zum:

(iv.a) Bestimmen (1205) von Randbedingungen für das zumindest eine variable Impedanzelement (702), wobei die Randbedingungen korrespondieren zu Impedanzen von dem zumindest einen variablen Impedanzelement (702), welche resultieren würden in einen gegebenen Spannungsstehwellenverhältnis für den Sender, operierend bei der gewünschten Frequenz, und

(iv.b) Verbessern des Empfangssignal Stärkenindikator Wertes durch schrittweises Modifizieren (1206) der Reaktanz von dem zumindest einen variablen Impedanzelement (702) innerhalb der bestimmten Randbedingungen.

7. Der Kontroller (105) gemäß irgendeinem vorherigen Anspruch,
wobei der Funkschaltkreis (100) konfiguriert ist zum Operieren auf einem Frequenzsignal, welches aktive Zeitslots (601, 603, 605, 607, 609) und Schutz Zeitslots (602, 604, 606, 610) hat; und
wobei der Kontroller (105) ferner konfiguriert ist zum Bereitstellen eines Steuersignals (110) zu dem zumindest einen variablen Impedanzelement (102) während eines Schutzslots (602, 604, 606, 610).

8. Der Kontroller (105) gemäß irgendeinem vorherigen Anspruch, wobei das zumindest eine variable Impedanzelement konfiguriert ist zum Dämpfen der Frequenzantwort von einem festen Frequenzsignal.

9. Ein Funkschaltkreis (100) aufweisend den Kontroller (105) gemäß irgendeinem der vorherigen Ansprüche, eine Antenne (101) und zumindest ein variables Impedanzelement (102).

**Revendications**

1. Contrôleur (105) pour un circuit radio (100), le circuit radio (100) comprenant au moins un élément à impédance variable (102) couplé entre une antenne (101) et un générateur d'indicateur d'intensité de signal reçu (104), le contrôleur (105) étant configuré pour :

   recevoir (501) un premier indicateur d'intensité de signal reçu en provenance du générateur d'indicateur d'intensité de signal reçu (104) ;
   fournir (502) un premier signal à l'au moins un élément à impédance variable (102), le premier signal comprenant une commande pour modifier la réactance de l'au moins un élément à impédance variable (102) par une première valeur de réactance ;
   recevoir (503) un deuxième indicateur d'intensité de signal reçu en provenance du générateur d'indicateur d'intensité de signal reçu (104) ;
   fournir (504) un deuxième signal à l'au moins un élément à impédance variable (102), le deuxième signal comprenant une commande pour modifier la réactance de l'au moins un élément à impédance variable (102) par une deuxième valeur de réactance ;
   recevoir (505) un troisième indicateur d'intensité de signal reçu en provenance du générateur d'indicateur d'intensité de signal reçu (104) ;
   calculer (506) une réactance de l'antenne (101) à l'aide d'une équation différentielle après les trois mesures de l'indicateur d'intensité de signal reçu et les deux variations de la réactance de l'élément à impédance variable (102), par :

   (i) réarrangement de :

   $$\frac{RSSI_2 - RSSI_1}{X_1} = -\frac{20}{ln\,10} \cdot \frac{(X_{ant} + X_M)}{\left[(R_{ant} + F)^2 + (X_{ant} + X_M)^2\right]}$$

   sous la forme d'un polynôme d'ordre 2 pour fournir deux solutions possibles pour la réactance de l'antenne, $X_{ant}$, où :

   $RSSI_1$ est le premier indicateur d'intensité de signal reçu,
   $RSSI_2$ est le deuxième indicateur d'intensité de signal reçu,
   $X_1$ est la première modification de valeur de réactance,
   $X_M$ est la valeur initiale de l'au moins un élément à impédance variable avant le changement par la première valeur de réactance,
   $R_{ant}$ est un paramètre de conception, et
   $F$ est un facteur représentant une partie réelle d'un modèle d'impédance série équivalent de l'EIV qui est chargé/terminé par l'impédance d'entrée de circuit radio ;

   (ii) résolution de :

   $$\left[\frac{(RSSI_3 - RSSI_2)/X_2 - (RSSI_2 - RSSI_1)/X_1}{(X_2 + X_1)/2}\right]$$

   pour produire un premier quotient, RSSI", où :

   $RSSI_3$ est le deuxième indicateur d'intensité de signal reçu, et
   $X_2$ est la deuxième modification de valeur de réactance ;

   (iii) substitution des deux valeurs possibles pour la réactance de l'antenne $X_{ant}$ calculée en (i) dans l'équation :

$$\frac{20}{ln10} \cdot \frac{\left[\left(R_{ant} + F\right)^2 - \left(X_{ant} + X_M\right)^2\right]}{\left[\left(R_{ant} + F\right)^2 + \left(X_{ant} + X_M\right)^2\right]^2}$$

pour produire des deuxième et troisième quotients respectifs,

(iv) sélection de l'une des valeurs possibles pour la réactance de l'antenne $X_{ant}$ à partir de (i) par détermination du fait que les deuxième et troisième quotients coïncident avec le premier quotient ; et

fourniture d'un signal de commande (100) à l'au moins un élément à impédance variable (102), le signal de commande (100) comprenant une commande pour régler (507) l'impédance de l'élément à impédance variable (102) en fonction de la réactance déterminée de l'antenne (101).

2. Contrôleur (705) selon la revendication 1, dans lequel le circuit radio (700) comprend un émetteur configuré pour générer un signal radioélectrique ayant un créneau temporel de garde (803, 807, 811) précédant un créneau temporel actif d'émetteur (804, 808, 812), et

le contrôleur (705) étant en outre configuré pour fournir un signal de commande (710) à l'au moins un élément à impédance variable (702) pendant le créneau de garde (803, 807, 811), le signal de commande (710) comprenant une commande destinée à l'au moins un élément à impédance variable (702) pour le réglage de son impédance de façon à faire coïncider au moins partiellement l'impédance de sortie de l'émetteur avec l'impédance apparente de l'antenne (701).

3. Contrôleur (705) selon la revendication 2, dans lequel le signal de commande (710) comprend une commande destinée à l'au moins un élément à impédance variable (702) pour le réglage de son impédance de telle sorte qu'une impédance apparente de l'antenne (701) soit le conjugué complexe d'une impédance entre une impédance de sortie d'un émetteur et un niveau d'impédance déterminé en réponse à la valeur d'un indicateur d'intensité de signal reçu à une fréquence comprise entre les fréquences de fonctionnement de l'émetteur et du récepteur.

4. Contrôleur (705) selon la revendication 2, configuré en outre pour :

recevoir (901) un indicateur d'intensité de signal reçu en provenance du générateur d'indicateur d'intensité de signal reçu (104) ;
déterminer (902) si l'indicateur d'intensité de signal reçu est supérieur ou inférieur à une valeur seuil ; et

si le niveau de l'indicateur d'intensité de signal reçu est supérieur à la valeur seuil, fournir (903) un signal de commande de transmission (710) à l'au moins un élément à impédance variable (702), le signal de commande de transmission (710) comprenant une commande pour régler l'impédance de l'au moins un élément à impédance variable (702) afin de faire coïncider au moins partiellement une impédance de sortie d'un émetteur, ou

si le niveau de l'indicateur d'intensité de signal reçu est inférieur à un niveau seuil, fournir (904) un signal de commande de réception (710) à l'au moins un élément à impédance variable (702), le signal de commande de réception (710) comprenant une commande pour régler l'impédance de l'au moins un élément à impédance variable (702) en réponse à la valeur de l'indicateur d'intensité de signal reçu.

5. Contrôleur (705) selon l'une quelconque des revendications précédentes, comprenant en outre une mémoire contenant des valeurs prédéfinies pour l'au moins un élément à impédance variable (702) correspondant à :

des impédances de sortie d'un étage émetteur à une pluralité de fréquences ; et/ou
des impédances d'entrée d'un étage récepteur à une pluralité de fréquences,
le contrôleur étant configuré pour régler la réactance de l'EIV en fonction d'une valeur prédéfinie d'un élément à impédance variable (702) correspondant à la fréquence de fonctionnement du circuit radio.

6. Contrôleur selon la revendication 5, configuré en outre pour :

(i) déterminer une impédance de l'antenne (701) à une fréquence d'émetteur souhaitée par le fait de rechercher (1201) l'impédance de l'antenne et/ou l'impédance de sortie de l'émetteur à la fréquence d'émetteur souhaitée stockée dans la mémoire ;
(ii) fournir (1202) un premier signal à l'au moins un élément à impédance variable (702), le premier signal comprenant une commande destinée à l'au moins un élément à impédance variable (702) pour le réglage de son impédance à une valeur d'impédance, la valeur d'impédance étant globalement égale au conjugué complexe de l'impédance de sortie de l'émetteur fonctionnant à la fréquence souhaitée moins l'impédance de l'antenne (701) à la fréquence souhaitée ;

(iii) recevoir (1203) un indicateur d'intensité de signal reçu en provenance du générateur d'indicateur d'intensité de signal reçu (704) ;

(iv) déterminer (1204) si l'indicateur d'intensité de signal reçu est inférieur à une valeur seuil, et si l'indicateur d'intensité de signal reçu est inférieur à la valeur seuil, le contrôleur est configuré pour :

(iv.a) déterminer (1205) des conditions limites pour l'au moins un élément à impédance variable (702), les conditions limites correspondant aux impédances de l'au moins un élément à impédance variable (702) qui résulteraient en un rapport d'onde stationnaire en tension donné pour l'émetteur fonctionnant à la fréquence souhaitée, et

(iv.b) améliorer la valeur de l'indicateur d'intensité de signal reçu en modifiant itérativement (1206) la réactance de l'au moins un élément à impédance variable (702) dans les conditions limites déterminées.

7. Contrôleur (105) selon l'une quelconque des revendications précédentes, dans lequel le circuit radio (100) est configuré pour fonctionner sur un signal radioélectrique ayant des créneaux temporels actifs (601, 603, 605, 607, 609) et des créneaux temporels de garde (602, 604, 606, 610) ; et

le contrôleur (105) étant en outre configuré pour fournir un signal de commande (110) à l'au moins un élément à impédance variable (102) pendant un créneau de garde (602, 604, 606, 610).

8. Contrôleur (105) selon l'une quelconque des revendications précédentes, dans lequel l'au moins un élément à impédance variable est configuré pour supprimer la réponse en fréquence d'un signal à fréquence fixe.

9. Circuit radio (100) comprenant le contrôleur (105) selon l'une quelconque des revendications précédentes, une antenne (101) et au moins un élément à impédance variable (102).

Figure 1

Figure 2

301

$jX_{ant} = j53.03\ \Omega$

320

321

$R_{ant} = 40\ \Omega$

322

306

302

$jX_{M0} = -j12.571\ \Omega$

323

307

324

$R = 50\ \Omega$

325

Figure 3

401

422

406

426

427

402

407

412

413

411

Figure 4

601    603    605    607    609

602    604    606    608    610

$\rightarrow$ t

Figure 6

**501** Receive a first RSQI

**502** Provide a first signal to VIE

**503** Receive a second RSQI

**504** Provide a second signal to VIE

**505** Receive a third RSQI

**506** Solve for $X_{ant}$

**507** Set matching VIE value(s)

Figure 5

801
802 RX
803
804 TX
805
806 RX
807
808 TX
809
810 RX
811
812 TX
813
814 RX
816
815
817 RX

t

Figure 8

Figure 7

Figure 9

```
┌──────────────┐          ┌──────────────┐
│ 1001 Receive │          │ 1201 Look-up │
│ a first RSQI │          │ VIE values   │
│ (RSQI₁)      │          │ suitable for TX│
│              │          │ mode         │
└──────┬───────┘          └──────┬───────┘
       │                         │
       ▼                         ▼
┌──────────────┐          ┌──────────────┐
│ 1002 Provide a│◄─┐      │ 1202 Provide │
│ signal to VIE │  │      │ a signal to VIE│
│ indicative of │  │      │              │
│ ΔX₊ change    │  │      │              │
└──────┬───────┘  │      └──────┬───────┘
       │          │             │
       ▼          │             ▼
┌──────────────┐  │      ┌──────────────┐
│ 1003 Receive │  │      │ 1203 Receive │◄─ ─ ┐
│ a second     │  │      │ RSQI         │     │
│ RSQI (RSQI₂) │  │      │              │     │
└──────┬───────┘  │      └──────┬───────┘     │
       │          │             │         [Optional]
       ▼          │             ▼              │
    ◇1004◇    YES │          ◇1204◇    YES  ┌──┴──────┐
  Is RSQI₂ >  ────┘       Determine if ─ ─ ─│ 1207    │
    RSQI₁?              RSQI > T            │ END     │
       │                      │            └─────────┘
      NO                     NO
       ▼                      ▼
┌──────────────┐      ┌──────────────┐   ┌──────────────┐
│ 1005 Provide a│      │ 1205 Determine│──▶│ 1206 Perform │
│ signal to VIE │      │ boundary     │   │ iterative method│
│ indicative of │      │ conditions   │   │ within boundary│
│ ΔX₋ change    │      │              │   │ conditions   │
└──────────────┘      └──────────────┘   └──────────────┘
```

Figure 10                    Figure 12

Figure 11

Figure 13

Figure 14

Figure 15

1602 GPS notch with tuning for low insertion loss at wireless channel frequencies

1601 GPS notch without tuning to improve the insertion loss at wireless channel frequencies

1603 Dual GPS notch with tuning for low insertion loss at wireless channel frequencies

m2
freq=1.710GHz
dB(Adaptive_matching_filters4..S(2,1))=-2.3156-5
Max

m1
freq=1.576GHz
dB(Adaptive_matching_filters4..S(2,1))=-144.865

freq, GHz

Figure 16

$$R_{int1} = \sqrt{R_{1761}R_{int2}} \qquad R_{int2} = \sqrt{R_{1775}R_{int1}}$$

Figure 17

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2008007330 A
- US 20090021325 A1
- WO 2004008634 A1
- US 20090231220 A1
- EP 2288023 A2
- EP 1137192 A1
- US 20070285326 A1

### Non-patent literature cited in the description

- **J BUCKLEY et al.** The Detuning Effects of a Wrist-Wom Antenna and Design of a Custom Antenna Measurement System. *Proc. 40th Euro. Microwave Conf.,* 2010, 1738-1741
- **E. L. FIRRAO et al.** An Automatic Antenna Tuning System Using Only RF Signal Amplitudes. *IEEE Transactions on circuits & Systems -II: Express Briefs,* 2008, vol. 55, 833-837
- **A. VAN BEZOOIJEN et al.** RF-MEMS based adaptive antenna matching module. *IEEE Radio Frequency Integrated Circuits Symposium,* 2007